(19) Europäisches Patentamt
European Patent Office
Office européen des brevets

(11) **EP 4 158 360 B1**

(12) **EUROPÄISCHE PATENTSCHRIFT**

(45) Veröffentlichungstag und Bekanntmachung des Hinweises auf die Patenterteilung:
**22.05.2024   Patentblatt 2024/21**

(21) Anmeldenummer: **21739659.7**

(22) Anmeldetag: **05.07.2021**

(51) Internationale Patentklassifikation (IPC):
***G01R 15/06*** *(2006.01)*    ***G01R 31/62*** *(2020.01)*

(52) Gemeinsame Patentklassifikation (CPC):
**G01R 15/06; G01R 31/62**

(86) Internationale Anmeldenummer:
**PCT/EP2021/068482**

(87) Internationale Veröffentlichungsnummer:
**WO 2022/012989 (20.01.2022 Gazette 2022/03)**

(54) **VERFAHREN UND VORRICHTUNG ZUM BESTIMMEN EINES ZUSTANDS EINES KAPAZITIVEN SPANNUNGSWANDLERS**

METHOD AND APPARATUS FOR DETERMINING A STATE OF A CAPACITIVE VOLTAGE TRANSFORMER

PROCÉDÉ ET DISPOSITIF POUR DÉTERMINER UN ÉTAT D'UN TRANSFORMATEUR CONDENSATEUR DE TENSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.07.2020   AT 506072020**

(43) Veröffentlichungstag der Anmeldung:
**05.04.2023   Patentblatt 2023/14**

(73) Patentinhaber: **Omicron electronics GmbH**
**6833 Klaus (AT)**

(72) Erfinder:
• **BISCHOF, Thomas**
**6830 Rankweil (AT)**
• **GOPP, David**
**6850 Dornbirn (AT)**

(74) Vertreter: **Kraus & Lederer PartGmbB**
**Thomas-Wimmer-Ring 15**
**80539 München (DE)**

(56) Entgegenhaltungen:
US-B2- 9 817 053

• **Gopp David: "Einflussgrößen bei der modellbasierten Prüfung von kapazitiven Spannungswandlern - Was sind die einflussreichsten Parameter der modellbasierten Prüfung von kapazitiven Spannungswandlern und wie wirken sich diese auf den Übersetzungs-und Phasenfehler aus?", Masterarbeit Fachhochschule Vorarlberg, 1. August 2019 (2019-08-01), Seiten 1-104, XP055828668, DOI: 10.25924/opus-3147 Gefunden im Internet: URL:https://opus.fhv.at/frontdoor/deliver/ index/docld/3147/file/Masterarbeit_Gopp.pd f [gefunden am 2021-07-29]**

**Beschreibung**

GEBIET DER ERFINDUNG

Die vorliegende Erfindung betrifft ein Verfahren zum Bestimmen eines Zustands eines kapazitiven Spannungswandlers, insbesondere zum Bestimmen von Defekten in einem kapazitiven Spannungsteiler in dem kapazitiven Spannungswandler. Die vorliegende Erfindung betrifft ferner eine Vorrichtung zum Bestimmen eines Zustands eines kapazitiven Spannungswandlers, welche das Verfahren implementiert.

HINTERGRUND

Spannungswandler werden im Bereich der elektrischen Energietechnik als Messwandler zum Messen von Wechselspannungen verwendet. Die Funktion eines Spannungswandlers besteht darin, die zu messende hohe Spannung auf geringe Spannungswerte proportional zu übertragen. Diese geringere Spannung, beispielsweise Werte um 100 V, wird an Spannungsmessgeräte, Energiezähler und ähnliche Geräte übermittelt, beispielsweise für Messzwecke oder Schutzzwecke. Spannungswandler können als induktive und als kapazitive Spannungswandler realisiert werden, wobei kapazitive Spannungswandler beispielsweise für primäre Bemessungsspannungen (Nennwerte) bis über 1 MV ausgelegt sein können.

Kapazitive Spannungswandler umfassen auf der Hochspannungsseite einen kapazitiven Spannungsteiler, welcher üblicherweise aus mindestens zwei in Reihe geschalteten Kondensatoren besteht. Üblicherweise ist ein Ende der Reihenschaltung der Kondensatoren mit der zu messenden Hochspannung verbunden und das andere Ende der Reihenschaltung mit Masse. An einem Abgriff zwischen den Kondensatoren liegt eine der zu messenden Hochspannung proportionale niedrigere Spannung an, welche über beispielsweise einen Transformator einem Spannungsmessgerät zugeführt werden kann.

Fehler im kapazitiven Spannungswandler können durch Defekte im kapazitiven Spannungsteiler verursacht werden. Es gibt verschiedene Gründe für Defekte in den Kondensatoren des kapazitiven Spannungsteilers, beispielsweise das Eindringen von Feuchtigkeit in die Isolierung. Eine Überwachung der Entwicklung der Kapazitätsänderung über der Zeit, ein sogenanntes "Trending", kann dazu beitragen, einen Totalausfall des kapazitiven Spannungswandlers zu verhindern. Ein Totalausfall könnte andere Geräte beschädigen, beispielsweise an den kapazitiven Spannungswandler angeschlossene Messgeräte, und Menschen gefährden. Um die zeitliche Entwicklung der Kapazitätsänderung zu verfolgen und Fehler der einzelnen Kondensatoren zu bestimmen, werden die Kapazitäten der Kondensatoren gemessen, beispielsweise mittels einer Analyse der Übertragungsfunktion (Sweep Frequency Response Analysis, SFRA). Diese Messungen basieren beispielsweise auf dem Prinzip der frequenzabhängigen Kurzschlussimpedanzmessung von der Sekundärseite des Transformators. Dazu wird die Reihenschaltung der Kondensatoren üblicherweise von der Hochspannung und von Masse getrennt. Insbesondere zum Trennen der Reihenschaltung der Kondensatoren von Masse ist eine Zugänglichkeit zu dem entsprechenden Anschlusspunkt erforderlich, was in der Realität häufig nicht oder nur unter erheblichem Montageaufwand gegeben ist.

Gopp David: "Einflussgrößen bei der modellbasierten Prüfung von kapazitiven Spannungswandlern - Was sind die einflussreichsten Parameter der modellbasierten Prüfung von kapazitiven Spannungswandlern und wie wirken sich diese auf den Übersetzungs-und Phasenfehler aus?", Masterarbeit Fachhochschule Vorarlberg, 1. August 2019 (2019-08-01), Seiten 1-104, XP055828668, DOI: 10.25924/opus-3147 offenbart ein Verfahren und eine Vorrichtung gemäß dem Oberbegriff der unabhängigen Ansprüche.

Die US 9 817 053 B2 offenbart einen kapazitiven Spannungswandler und die Bestimmung eines Kapazitätsverhältnisses durch Anlegen einer Testspannung an die Primärseite und, für einen induktiven Spannungswandler, eine Bestimmung einer Resonanzfrequenz durch Anlegen einer Spannung mit variabler Frequenz an eine Sekundärseite.

ZUSAMMENFASSUNG DER ERFINDUNG

Es besteht ein Bedarf an einem verbesserten Verfahren zur Überprüfung und Überwachung von Kondensatoren eines kapazitiven Spannungsteilers in einem kapazitiven Spannungswandler.

Gemäß der vorliegenden Erfindung wird ein Verfahren zum Bestimmen eines Zustands eines kapazitiven Spannungswandlers und eine Vorrichtung zum Bestimmen eines Zustands eines kapazitiven Spannungswandlers bereitgestellt, wie sie in den unabhängigen Ansprüchen definiert sind. Die abhängigen Ansprüche definieren Ausführungsformen der Erfindung.

Die vorliegende Erfindung stellt ein Verfahren zum Bestimmen eines Zustands eines kapazitiven Spannungswandlers bereit. Der kapazitive Spannungswandler umfasst an seiner Primärseite einen kapazitiven Spannungsteiler mit einem ersten Kondensator und einen zweiten Kondensator. Unter der Primärseite des kapazitiven Spannungswandlers wird in diesem Zusammenhang die Seite des kapazitiven Spannungswandlers bezeichnet, welche mit der zu messenden Hochspannung gekoppelt wird. Die Hochspannung kann beispielsweise eine Spannung von einigen 1000V bis hin zu einigen 1 00.000V oder sogar 1MV oder darüber hinaus aufweisen. Unter der Sekundärseite des kapazitiven Spannungswandlers wird daher die Seite des kapazitiven Spannungswandlers bezeichnet, welche mit dem Messgerät oder einer anderen Vorrichtung, beispielsweise einem Energiezähler, gekoppelt wird. Der erste Kondensator weist einen Hochspannungsanschluss zum Verbinden des ersten Kondensators mit der Hochspannung auf. Der zweite Kondensator weist einen Masseanschluss zum Verbinden des zweiten Kondensators mit Masse auf. Masse kann in diesem Zusammenhang beispielsweise ein Referenzpotential für die Hochspannung sein. Sowohl der erste Kondensator als auch der zweite Kondensator können jeweils mehrere in reihengeschaltete Kondensatoren umfassen, um die Spannungsfestigkeit des resultierenden Kondensators zu erhöhen. Der erste Kondensator und der zweite Kondensator können zur Bildung des kapazitiven Spannungsteilers beispielsweise in Reihe geschaltet werden, sodass eine Teilspannung der Hochspannung an dem Verbindungspunkt zwischen dem ersten und zweiten Kondensator abgegriffen werden kann. Der kapazitive Spannungswandler kann ferner einen Transformator umfassen, welchem an der Primärseite des Transformators die Spannung zwischen dem Verbindungspunkt und Masse zugeführt wird und welcher an der Sekundärseite des Transformators somit eine galvanisch getrennte Spannung bereitstellt, welche proportional zu der zwischen dem Verbindungspunkt und Masse abgegriffenen Spannung ist. Der Übertragungsfaktor des Transformators kann beispielsweise 1 betragen. Der Transformator kann einen beliebigen anderen Übertragungsfaktor aufweisen, insbesondere einen Übertragungsfaktor größer 1, sodass die von dem Spannungsteiler abgegriffene Spannung durch den Transformator heruntertransformiert wird.

Bei dem Verfahren wird eine erste Resonanzfrequenz mittels mehrerer erster Kurzschlussimpedanzmessungen bei verschiedenen Frequenzen an der Sekundärseite des kapazitiven Spannungswandlers bestimmt, während der Hochspannungsanschluss mit Masse verbunden ist. Weiterhin wird eine zweite Resonanzfrequenz mittels mehrerer zweiter Kurzschlussimpedanzmessungen bei verschiedenen Frequenzen an der Sekundärseite des kapazitiven Spannungswandlers bestimmt, während der Hochspannungsanschluss offen ist. Ein Kapazitätsverhältnis des kapazitiven Spannungsteilers wird in Abhängigkeit von der ersten Resonanzfrequenz und der zweite Resonanzfrequenz bestimmt. Das Kapazitätsverhältnis kann beispielsweise ein Verhältnis der Kapazität des zweiten Kondensators zu der Kapazität des ersten Kondensators oder ein Verhältnis des zweiten Kondensators zu der Summenkapazität des ersten und zweiten Kondensators sein. Bei sowohl der Bestimmung der ersten Resonanzfrequenz als auch bei der Bestimmung der zweiten Resonanzfrequenz kann der zweite Kondensator mit seinem Masseanschluss mit Masse verbunden bleiben.

Wenn sich die Kapazitäten der Kondensatoren des kapazitiven Spannungsteilers aufgrund von beispielsweise einem Verschleiß ändern, ändert sich im Allgemeinen auch das Kapazitätsverhältnis. Daher kann das Kapazitätsverhältnis als Indikator für einen Zustand des kapazitiven Spannungswandlers angesehen werden. Da das Kapazitätsverhältnis bestimmt werden kann, ohne den Masseanschluss des zweiten Kondensators von Masse zu trennen, kann der Zustand des kapazitiven Spannungsteilers schnell und kostengünstig bestimmt werden.

Bei dem Verfahren kann ferner ein Messstrom in Abhängigkeit einer Bürde des kapazitiven Spannungswandlers und einem Spannungsabfall an der Bürde des kapazitiven Spannungswandlers bestimmt werden. Die mehreren ersten Kurzschlussimpedanzmessungen und die mehreren zweiten Kurzschlussimpedanzmessungen werden unter Verwendung des Messstroms durchgeführt. Die Bürde des kapazitiven Spannungswandlers betrifft die Impedanz des Sekundärkreises des kapazitiven Spannungswandlers und wird üblicherweise durch die Scheinleistung ausgedrückt, die bei festgelegten Bedingungen aufgenommen wird. Die Kurzschlussimpedanzmessungen können somit gezielt bei einem Messstrom durchgeführt werden, dessen Amplitude nahe bei dem Nominalstrom ist, sodass die Resonanzfrequenzen schnell und zuverlässig ermittelt werden können.

Bei einer Ausführungsform umfassen die mehreren ersten Kurzschlussimpedanzmessungen mehrere Kurzschlussimpedanzmessungen in einem ersten Frequenzraster gefolgt von mehreren Kurzschlussimpedanzmessungen in einem zweiten Frequenzraster. Das erste Frequenzraster weist einen größeren Frequenzabstand als das zweite Frequenzraster auf. Alternativ oder zusätzlich können die mehreren zweiten Kurzschlussimpedanzmessungen mehrere Kurzschlussimpedanzmessungen in einem ersten Frequenzraster gefolgt von mehreren Kurzschlussimpedanzmessungen in einem zweiten Frequenzraster umfassen. Auch hier gilt, dass das erste Frequenzraster einen größeren Frequenzabstand als das zweite Frequenzraster hat. Anders ausgedrückt kann eine Resonanzfrequenz in einem ersten Durchlauf grob bestimmt werden. In dem ersten Durchlauf können Frequenzen in einem weiten Frequenzbereich in groben Schritten ausgewählt werden, um die Resonanzfrequenz mittels Kurzschlussimpedanzmessungen näherungsweise zu bestimmen. In einem zweiten Durchlauf kann die Resonanzfrequenz genauer bestimmt werden, indem der zweite Durchlauf in einem Frequenzbereich durchgeführt wird, welcher anhand des ersten Durchlaufs als der Frequenzbereich bestimmt wurde, welcher die Resonanzfrequenz umfasst. Dieser in dem ersten Durchlauf bestimmte Frequenzbereich kann in dem zweiten Durchlauf in kleinen Schritten abgetastet werden, um die Resonanzfrequenz genau zu bestimmen. Es können weitere Durchläufe durchgeführt werden, um die Resonanzfrequenz noch genauer zu bestimmen. Durch dieses iterative Verfahren können die erste und zweite Resonanzfrequenz schnell und zuverlässig bestimmt werden.

Bei dem Verfahren kann ferner eine Resonanzinduktivität des kapazitiven Spannungswandlers in Abhängigkeit von Nennwerten des ersten und zweiten Kondensators und einer Nennfrequenz des kapazitiven Spannungswandlers bestimmt werden. Die Nennwerte des ersten und zweiten Kondensators sowie die Nennfrequenz des kapazitiven Spannungswandlers können beispielsweise dem Typenschild des kapazitiven Spannungswandlers entnommen werden. Ein Istwert der Kapazität des zweiten Kondensators kann in Abhängigkeit von der zweiten Resonanzfrequenz und der Resonanzinduktivität bestimmt werden. Da bei der Bestimmung der zweiten Resonanzfrequenz der Hochspannungsanschluss offen ist, resultiert die zweite Resonanzfrequenz im Wesentlichen lediglich aus der Kapazität des zweiten Kondensators. In Verbindung mit der Resonanzinduktivität kann daher beispielsweise unter Verwendung der Thomsonschen Schwingungsgleichung der Istwert der Kapazität des zweiten Kondensators aus der zweiten Resonanzfrequenz bestimmt werden.

Bei weiteren Ausführungsformen können wie zuvor beschrieben mehrere Istwerte der Kapazität des zweiten Kondensators zu unterschiedlichen Zeitpunkten bestimmt werden und ein zeitlicher Trendverlauf der Kapazität des zweiten Kondensators aufgezeichnet und/oder auf einer Anzeigevorrichtung dargestellt werden. Anhand des zeitlichen Trendverlaufs kann extrapoliert oder geschätzt werden, ob der Zustand des kapazitiven Spannungswandlers für einen weiteren zuverlässigen Betrieb ausreicht.

In Abhängigkeit von dem Istwert der Kapazität des zweiten Kondensators und dem Kapazitätsverhältnis kann ein Istwert der Kapazität des ersten Kondensators bestimmt werden. Zu unterschiedlichen Zeitpunkten können mehrere Istwert der Kapazität des ersten Kondensators bestimmt werden und ein zeitlicher Trendverlauf der Kapazität des ersten Kondensators aufgezeichnet und/oder auf einer Anzeigevorrichtung dargestellt werden. Somit kann auch anhand des zeitlichen Trendverlaufs des ersten Kondensators extrapoliert oder geschätzt werden, ob der Zustand des kapazitiven Spannungswandlers für einen weiteren zuverlässigen Betrieb ausreichend ist.

Alternativ oder zusätzlich können mehrere Kapazitätsverhältnisse des kapazitiven Spannungsteilers zu unterschiedlichen Zeitpunkten bestimmt werden und ein zeitlicher Trendverlauf des Kapazitätsverhältnisses auf einer Anzeigevorrichtung dargestellt werden. Bei einer Zustandsänderung der Kondensatoren des kapazitiven Spannungsteilers ändert sich üblicherweise auch das Kapazitätsverhältnis der Kondensatoren zueinander. Anhand eines zeitlichen Verlaufs des Kapazitätsverhältnisses kann eine Verschlechterung des Zustands des kapazitiven Spannungsteilers auf einfache Art und Weise rechtzeitig erkannt werden.

Bei einer weiteren Ausführungsform wird eine erste Abhängigkeit des Kapazitätsverhältnisses von der ersten Resonanzfrequenz bestimmt. Die erste Abhängigkeit kann beispielsweise eine partielle Ableitung des Kapazitätsverhältnisses nach der ersten Resonanzfrequenz umfassen. Eine derartige Abhängigkeit wird auch als Sensitivität (englisch: sensitivity) des Kapazitätsverhältnisses in Bezug auf die erste Resonanzfrequenz bezeichnet. Mehrere der ersten Abhängigkeiten des Kapazitätsverhältnisses von der ersten Resonanzfrequenz können zu mehreren unterschiedlichen Zeitpunkten bestimmt werden und ein zeitlicher Trendverlauf der ersten Abhängigkeit auf einer Anzeigevorrichtung dargestellt werden.

Ferner kann eine zweite Abhängigkeit des Kapazitätsverhältnisses von der zweiten Resonanzfrequenz bestimmt werden. Die zweite Abhängigkeit kann beispielsweise eine partielle Ableitung des Kapazitätsverhältnisses nach der zweiten Resonanzfrequenz umfassen. Mehrere der zweiten Abhängigkeiten des Kapazitätsverhältnisses von der zweiten Resonanzfrequenz können zu mehreren unterschiedlichen Zeitpunkten bestimmt werden und ein zeitlicher Trendverlauf der zweiten Abhängigkeit auf eine Anzeigevorrichtung dargestellt werden.

Der zeitliche Trendverlauf der ersten Abhängigkeit spiegelt eine Sensitivität der Gesamtkapazität des ersten und zweiten Kondensators wider und der zeitliche Trendverlauf der zweiten Abhängigkeit spiegelt eine Sensitivität der Kapazität des zweiten Kondensators wider. Bei einer Änderung der ersten und/oder zweiten Sensitivität über der Zeit, das heißt, durch Analyse des jeweiligen zeitlichen Trendverlaufs der ersten bzw. zweiten Sensitivität über der Zeit, kann auf Zustandsänderungen des ersten und/oder zweiten Kondensators geschlossen werden.

Die vorliegende Erfindung stellt ferner eine Vorrichtung zum Bestimmen eines Zustands eines kapazitiven Spannungswandlers bereit. Der kapazitive Spannungswandler umfasst an seiner Primärseite einen kapazitiven Spannungsteiler mit einem ersten Kondensator und einem zweiten Kondensators. Der erste Kondensator weist einen Hochspannungsanschluss zum Verbinden mit einer Hochspannung auf. Der zweite Kondensator weist einen Masseanschluss auf. Der erste Kondensator und der zweite Kondensator können beispielsweise eine Reihenschaltung bilden, um den kapazitiven Spannungsteiler auszubilden. Die Vorrichtung umfasst eine Messvorrichtung, welche zur Durchführung einer Kurzschlussimpedanzmessung mit einstellbarer Frequenz ausgestaltet ist. Die Vorrichtung umfasst ferner eine Steuervorrichtung, beispielsweise eine elektronische Steuerung mit einem Mikroprozessor, welche ausgestaltet ist, eine erste Resonanzfrequenz mittels mehrerer erster Kurzschlussimpedanzmessungen bei verschiedenen Frequenzen an einer Sekundärseite des kapazitiven Spannungswandlers zu bestimmen, während der Hochspannungsanschluss mit Masse verbunden ist. Die Steuervorrichtung ist ferner ausgestaltet, eine zweite Resonanzfrequenz mittels mehrerer zweiter Kurzschlussimpedanzmessungen bei verschiedenen Frequenzen an der Sekundärseite des kapazitiven Spannungswandlers zu bestimmen, während der Hochspannungsanschluss offen ist. In Abhängigkeit von der erste Resonanzfrequenz und der zweiten Resonanzfrequenz bestimmt die Steuervorrichtung ein Kapazitätsverhältnis des kapazitiven Spannungsteilers.

Die Vorrichtung ist zur Durchführung des zuvor beschriebenen Verfahrens und den zuvor beschriebenen Ausführungsformen des Verfahrens geeignet und umfasst daher auch die zuvor beschriebenen Vorteile.

KURZE BESCHREIBUNG DER FIGUREN

Die Erfindung wird nachfolgend unter Bezugnahme auf die Zeichnungen anhand bevorzugter Ausführungsformen näher erläutert. In den Zeichnungen bezeichnen identische Bezugszeichen identische Elemente.

Fig. 1 zeigt schematisch einen kapazitiven Spannungswandler in Verbindung mit einer Hochspannungsleitung.

Fig. 2 zeigt schematisch eine Verschaltung des kapazitiven Spannungswandlers der Fig. 1 zum Bestimmen einer ersten Resonanzfrequenz.

Fig. 3 zeigt schematisch eine Verschaltung des kapazitiven Spannungswandlers der Fig. 1 zum Bestimmen einer zweiten Resonanzfrequenz.

Fig. 4 zeigt schematisch eine Verschaltung des kapazitiven Spannungswandlers der Fig. 1 zum Bestimmen einer weiteren Resonanzfrequenz.

Fig. 5 zeigt schematisch Kurzschlussimpedanzmessungen bei verschiedenen Frequenzen zur Bestimmung der ersten bzw. zweiten Resonanzfrequenz gemäß einer Ausführungsform.

Fig. 6 zeigt schematisch Phasenwinkel bei Kurzschlussimpedanzmessungen bei verschiedenen Frequenzen zur Bestimmung der ersten Resonanzfrequenz bzw. zweiten Resonanzfrequenz gemäß einer Ausführungsform.

Fig. 7 zeigt schematisch Kurzschlussimpedanzmessungen bei verschiedenen Frequenzen zur Bestimmung der weiteren Resonanzfrequenz gemäß einer Ausführungsform.

Fig. 8 zeigt schematisch Phasenwinkel bei Kurzschlussimpedanzmessungen bei verschiedenen Frequenzen zur Bestimmung der weiteren Resonanzfrequenz gemäß einer Ausführungsform.

Fig. 9 zeigt schematisch eine Abhängigkeit eines Kapazitätsverhältnisses von der zweiten Resonanzfrequenz gemäß einer Ausführungsform.

Fig. 10 zeigt schematisch eine Abhängigkeit eines Kapazitätsverhältnisses von der ersten Resonanzfrequenz gemäß einer Ausführungsform.

Fig. 11 zeigt schematisch eine Abhängigkeit eines Kapazitätsverhältnisses von einer Kapazität eines zweiten Kondensators eines kapazitiven Spannungsteilers gemäß einer Ausführungsform.

Fig. 12 zeigt schematisch eine Abhängigkeit eines Kapazitätsverhältnisses von einer Kapazität eines ersten Kondensators eines kapazitiven Spannungsteilers gemäß einer Ausführungsform.

Fig. 13 zeigt Verfahrensschritte zum Bestimmen eines Zustands eines kapazitiven Spannungswandlers gemäß einer Ausführungsform.

Fig. 14 zeigt Verfahrensschritte zum Bestimmen eines Zustands eines kapazitiven Spannungswandlers gemäß einer weiteren Ausführungsform.

Fig. 15 zeigt Verfahrensschritte zum Bestimmen eines Zustands eines kapazitiven Spannungswandlers gemäß noch einer weiteren Ausführungsform.

DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein.

Nachfolgend werden Verfahren und Vorrichtungen zum Bestimmen eines Zustands eines kapazitiven Spannungswandlers detailliert beschrieben. Der Zustand eines kapazitiven Spannungswandlers kann durch Defekte an den Kondensatoren des kapazitiven Spannungsteilers beeinträchtigt werden. Es gibt verschiedene Gründe für Defekte an den Kondensatoren, beispielsweise ein Eindringen von Feuchtigkeit in die Isolierung. Eine Überwachung der Kapazitätsänderung über der Zeit kann dazu beitragen, einen Totalausfall des kapazitiven Spannungsteilers zu verhindern. Ein Totalausfall kann andere Einrichtungsteile oder Menschen gefährden. Für eine Beurteilung der Kapazitätsänderung über der Zeit und für eine Lokalisierung der Defekte in den Kondensatoren des kapazitiven Spannungsteilers kann es erforderlich sein, die Kapazitäten der Kondensatoren getrennt voneinander zu ermitteln.

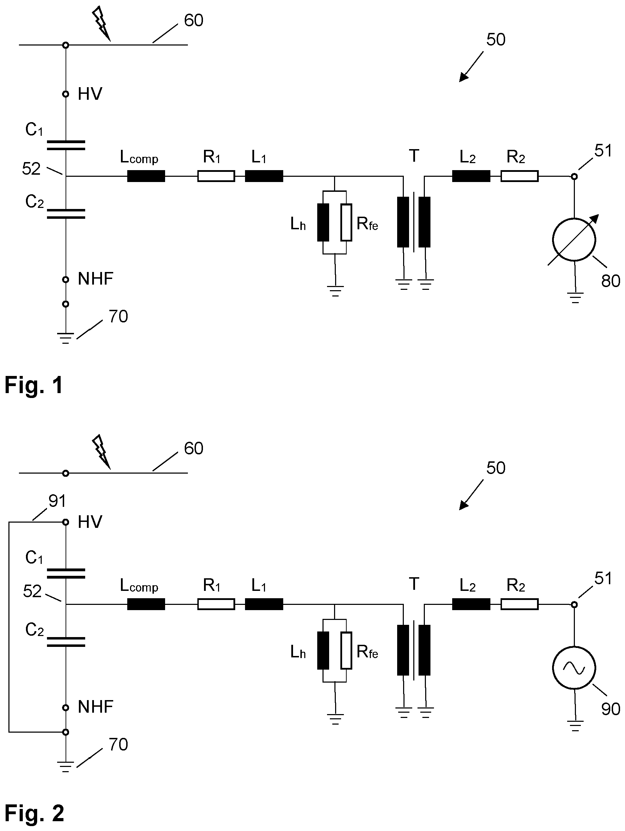

Fig. 1 zeigt schematisch einen kapazitiven Spannungswandler 50, welcher über einen Hochspannungsanschluss HV des Spannungswandlers 50 mit einer Hochspannungsleitung 60 gekoppelt ist. Der kapazitive Spannungswandler 50 umfasst zwei in reihengeschaltete Kondensatoren $C_1$ und $C_2$, welche einen Spannungsteiler bilden. Der erste Kondensator $C_1$ ist mit dem Hochspannungsanschluss HV verbunden und der zweite Kondensator $C_2$ ist über einen Anschluss NHF mit Masse 70 verbunden. An der Verbindung zwischen dem ersten Kondensator $C_1$ und dem zweiten Kondensator $C_2$ ist ein Abgriff 52 vorgesehen, an welchem im Betrieb des Spannungswandlers 50 eine Teilspannung der Hochspannung 60 abgegriffen werden kann. Die abgegriffene Spannung wird über eine Kompensationsinduktivität $L_{comp}$ an eine Primärwicklung eines Transformators T geleitet. An der Sekundärwicklung des Transformators T steht eine potenzialfreie Messspannung, welche erheblich kleiner als und proportional zu der Hochspannung auf der Hochspannungsleitung 60 ist, bereit und kann beispielsweise mit einem Messgerät 80 an einem Anschluss 51 an der Sekundärseite des Transformators T gemessen werden. In der schematischen Darstellung der Fig. 1 ist der Transformator T als ein idealer Transformator dargestellt. Die nicht idealen Eigenschaften eines entsprechenden realen Transformators werden in Fig. 1 durch einen Wicklungswiderstand $R_1$ und eine Streuinduktivität $L_1$ an der Primärseite, einen Wicklungswiderstand $R_2$ und eine Streuinduktivität $L_2$ an der Sekundärseite, eine Hauptinduktivität $L_h$ und Eisenverluste $R_{fe}$ modelliert.

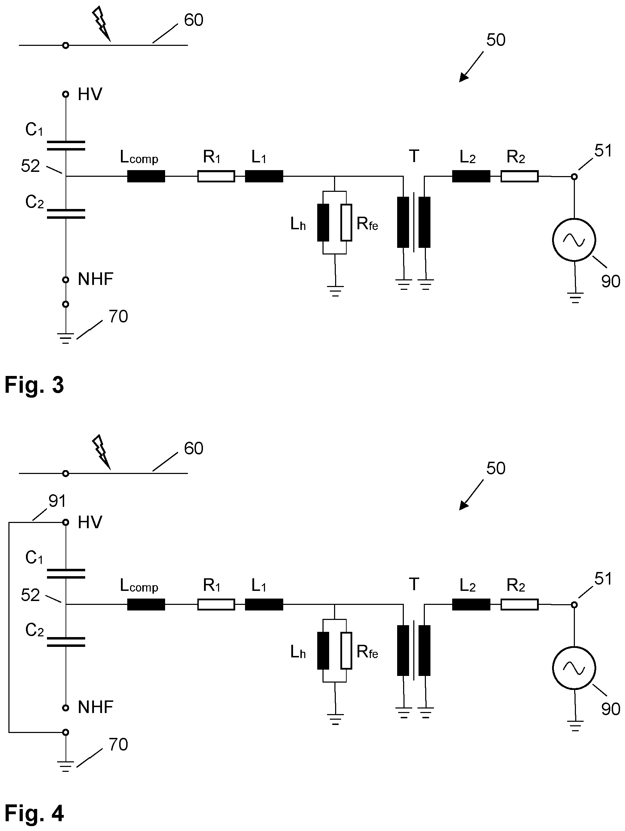

Wie nachfolgend unter Bezugnahme auf die Figuren 2 bis 4 beschrieben werden wird, können die Kapazitäten der Kondensatoren $C_1$ und $C_2$ mit unterschiedlichen Messungen zur Analyse der Übertragungsfunktion (englisch: Sweep Frequency Response Analysis, SFRA) unterschieden werden. Diese Messungen basieren auf dem Prinzip von frequenzabhängigen Kurzschlussimpedanzmessungen an der Sekundärseite des Transformators T. Es ist zu beachten, dass für die Messung gemäß Fig. 4 der Anschluss NHF von Masse getrennt werden muss. Dies ist jedoch nur möglich, wenn der Anschluss NHF zugänglich und von Masse trennbar ist. Daher kann es vorteilhaft sein, den Zustand des kapazitiven Spannungswandlers ohne die Messung gemäß Fig. 4 zu bestimmen. Bei allen Messungen gemäß der Figuren 2 bis 4 ist der Hochspannungsanschluss HV des Spannungswandlers von der Hochspannungsleitung 60 zu trennen.

Bei dem in Fig. 2 gezeigten Messaufbau ist der Hochspannungsanschluss HV über eine zusätzliche Leitung 91 mit Masse 70 verbunden. Der Anschluss NHF ist ebenfalls mit Masse 70 verbunden, sodass die Kondensatoren $C_1$ und $C_2$ zwischen dem Abgriff 52 und Masse 70 parallel geschaltet sind. Mit einem Messgerät 90, welches an dem Anschluss 51 an der Sekundärseite des Transformators T angeschlossen ist, wird eine Kurzschlussimpedanzmessung an der Sekundärseite des Transformators T, also an der Niederspannungsseite des kapazitiven Spannungswandlers 50 durchgeführt. Die Kurzschlussimpedanzmessung wird weiter unten im Detail beschrieben werden.

Bei dem in Fig. 3 gezeigten Messaufbau ist der Hochspannungsanschluss HV offen und der Anschluss NHF ist mit Masse 70 verbunden. Zwischen dem Abgriff 52 und Masse ist nun im Wesentlichen lediglich der zweite Kondensator $C_2$ geschaltet. Mit dem Messgerät 90 wird eine Kurzschlussimpedanzmessung an der Sekundärseite des Transformators T durchgeführt.

Fig. 4 zeigt einen Messaufbau, bei welchem der Hochspannungsanschluss HV über eine zusätzliche Leitung 91 mit Masse verbunden ist und der Anschluss NHF offen ist, sodass zwischen dem Abgriff 52 und Masse 70 im Wesentlichen lediglich der erste Kondensator $C_1$ geschaltet ist. Mit dem Messgerät 90 wird eine Kurzschlussimpedanzmessung an der Sekundärseite des Transformators T durchgeführt.

Die in den Figuren 2 bis 4 gezeigten Messaufbauten unterscheiden sich dadurch, dass unterschiedliche kapazitive Lasten auf der Primärseite des kapazitiven Spannungswandlers während der frequenzabhängigen Kurzschlussimpedanzmessung wirken. In Fig. 2 sind die Kondensatoren $C_1$ und $C_2$ beide mit Masse verbunden, sodass die Parallelschaltung von $C_1$ und $C_2$ als kapazitive Last wirkt. In Fig. 3 wirkt lediglich der Kondensator $C_2$ als kapazitive Last und in Fig. 4 wirkt lediglich der Kondensator $C_1$ als kapazitive Last.

Wie nachfolgend beschrieben werden wird, kann mittels zweier unterschiedlicher frequenzabhängiger Kurzschlussimpedanzmessungen an der Sekundärseite des kapazitiven Spannungswandlers ein Kapazitätsverhältnis Kc zwischen der Kapazität des Kondensators $C_1$ und der Kapazität des Kondensators $C_2$ bestimmt werden, auch ohne Kenntnis des induktiven Übersetzungsverhältnisses des kapazitiven Spannungswandlers, welches über das Verhältnis der sekundären und primären Windungszahlen definiert ist. Die frequenzabhängigen Kurzschlussimpedanzmessungen werden mittels eines Stromsignals ausgeführt, welches eine Amplitude aufweist, die im Wesentlichen einem Nennstrom des kapazitiven Spannungswandlers entspricht oder nahe bei diesem Nennstrom liegt. Während der frequenzabhängigen Kurzschlussimpedanzmessung wird die Frequenz allmählich geändert, beispielsweise in Schritten von einer niedrigen Startfrequenz zu einer höheren Endfrequenz erhöht. Die Stromstärke des Stromsignals, also eines Messstroms, kann unter Verwendung von Informationen des Typenschilds des kapazitiven Spannungswandlers bestimmt und eingestellt werden. Beispielsweise kann der Messstrom basierend auf der auf dem Typenschild angegebenen Bürde $S_r$ und dem Spannungsabfall an der Bürde $U_{Sr}$ bestimmt und eingestellt werden. Die Bürde kann als Scheinleistung in der Einheit Voltampere (VA) angegeben sein, welche als Produkt des am Stromwandler sekundärseitig auftretenden Nennstromes und des zugehörigen Spannungsabfalls an der Bürde gebildet wird.

Beispielsweise kann eine Resonanzfrequenz durch mehrere Kurzschlussimpedanzmessungen bei unterschiedlichen Frequenzen bestimmt werden. Zum Beispiel kann die Frequenz, bei welcher eine jeweilige Kurzschlussimpedanzmessung durchgeführt wird, in einem ersten Durchlauf in groben Schritten erhöht werden, sodass der Bereich der Resonanzfrequenz grob eingegrenzt werden kann. In einem zweiten Durchlauf kann die Frequenz, bei welcher eine jeweilige Kurzschlussimpedanzmessung durchgeführt wird, in feineren Schritten in dem Bereich, der in dem ersten Durchlauf bestimmt worden ist, erhöht werden und somit die Resonanzfrequenz genauer bestimmt werden. Anders ausgedrückt können in dem ersten Durchlauf mehrere Kurzschlussimpedanzmessungen in einem ersten Frequenzraster durchgeführt werden und in dem zweiten Durchlauf mehrere Kurzschlussimpedanzmessungen in einem zweiten Frequenzraster durchgeführt werden, welches einen kleineren Frequenzabstand als das erste Frequenzraster aufweist.

Die Basis der nachfolgenden Betrachtungen ist die Thomsonsche Schwingungsgleichung (Gleichung 1), mit welcher sich die Resonanzfrequenz $\omega$ (=$2\pi f$) eines Schwingkreises mit einer Kapazität C und einer Induktivität L berechnen lässt. In den nachfolgenden Gleichungen werden Kreisfrequenzen mit $\omega$ und Schwingungszahlen mit f bezeichnet. Im Text werden diese Größen $\omega$ und f vereinfacht als Frequenzen bezeichnet.

$$\text{Gleichung 1:} \qquad \omega^2 = \frac{1}{L*C}$$

Resonanzfrequenzen können für die in den Figuren 2 bis 4 gezeigten Schwingkreise bestimmt werden. Die Resonanzfrequenzen können verwendet werden, um das Kapazitätsverhältnis zu bestimmen. Mit den in den Figuren 2 bis 4 gezeigten Schwingkreisen können aus entsprechenden frequenzabhängigen Kurzschlussimpedanzmessungen drei Resonanzfrequenzen bestimmt werden.

Für die Schaltung nach Fig. 2 kann eine erste Resonanzfrequenz $\omega_e$ bestimmt werden, welche von der Summe der Kapazitäten der Kondensatoren $C_1$ und $C_2$ gemäß Gleichung 2 abhängt.

$$\text{Gleichung 2:} \qquad \omega_e = \frac{1}{\sqrt{L*(C_1+C_2)}} \rightarrow \omega_e^2 = \frac{1}{L*(C_1+C_2)}$$

Für die Schaltung nach Fig. 3 kann eine zweite Resonanzfrequenz $\omega_2$ bestimmt werden, welche von der Kapazität des Kondensators $C_2$ gemäß Gleichung 3 abhängt.

$$\text{Gleichung 3:} \qquad \omega_2 = \frac{1}{\sqrt{L*C_2}} \rightarrow \omega_2^2 = \frac{1}{L*C_2}$$

Für die Schaltung nach Fig. 4 kann eine weitere Resonanzfrequenz $\omega_1$ bestimmt werden, welche von der Kapazität des Kondensators $C_1$ gemäß Gleichung 4 abhängt.

$$\text{Gleichung 4:} \qquad \omega_1 = \frac{1}{\sqrt{L*C_1}} \rightarrow \omega_1^2 = \frac{1}{L*C_1}$$

Das Kapazitätsverhältnis Kc des kapazitiven Spannungswandlers 50 hängt von den einzelnen Kapazitäten des Spannungsteilers ab und kann als der Quotient aus der Summe der Kapazitäten der Kondensatoren $C_1$ und $C_2$ und der Kapazität des Kondensators $C_1$ definiert werden (Gleichung 5), vgl. auch International Standard IEC 61869-5, Sec. 3.1.528, Note 501.

$$\text{Gleichung 5:} \qquad K_c = \frac{C_1 + C_2}{C_1}$$

Die aus den frequenzabhängigen Kurzschlussimpedanzmessungen abgeleiteten Gleichungen 2 bis 4 können in Gleichung 5 eingesetzt werden. Auf diese Art und Weise können vier weitere Gleichungen (Gleichung 6 bis Gleichung 9) abgeleitet werden. In Gleichung 6 gehen die Resonanzfrequenzen $\omega_1$ und $\omega_e$ ein, in Gleichung 7 gehen die Resonanzfrequenzen $\omega_1$ und $\omega_2$ ein, in Gleichung 8 gehen die Resonanzfrequenzen $\omega_2$ und $\omega_e$ ein und in Gleichung 9 gehen die Resonanzfrequenzen $\omega_1$, $\omega_2$ und $\omega_e$ ein. Wie zuvor beschrieben wurde, kann die Bestimmung der Resonanzfrequenz $\omega_1$ problematisch sein, da dazu der Anschluss NHF von Masse zu trennen ist, was nicht immer (einfach) möglich ist. Daher wird nachfolgend hauptsächlich Gleichung 8 betrachtet werden, welche unabhängig von der Messung der Resonanzfrequenz $\omega_1$ ist.

$$\text{Gleichung 6:} \qquad K_c = \frac{\omega_1^2}{\omega_e^2}$$

$$\text{Gleichung 7:} \qquad K_c = \frac{\omega_1^2 + \omega_2^2}{\omega_2^2}$$

$$\text{Gleichung 8:} \qquad K_c = \frac{\omega_2^2}{\omega_2^2 - \omega_e^2}$$

$$\text{Gleichung 9:} \qquad K_c = \frac{\omega_e^2 * (\omega_2^2 + \omega_1^2)}{\omega_1^2 * (\omega_2^2 - \omega_e^2)}$$

Um mit dem kapazitiven Spannungsteiler bestehend aus den Kondensatoren $C_1$ und $C_2$ eine möglichst niedrige Messspannung proportional zu der Hochspannung bereitzustellen, kann für den Kondensator $C_2$ eine erheblich größere Kapazität gewählt werden als für die Kapazität des Kondensators $C_1$, d. h., $C_2 >> C_1$. Die Gesamtkapazität $C_1 + C_2$ in der Schaltung nach Fig. 2 unterscheidet sich daher nur wenig von der Kapazität des Kondensators $C_2$. Daraus folgt, dass sich die Resonanzfrequenzen $\omega_e$ und $\omega_2$ der Schaltungen nach Fig. 2 und nach Fig. 3 nur wenig voneinander unterscheiden. Eine Induktivität, welche einen entsprechenden Resonanzschaltkreis zusammen mit den Kapazitäten $C_1$ und /oder $C_2$ bildet, kann eine frequenzabhängige Nichtlinearität aufweisen. Die Induktivität, welche einen entsprechenden Resonanzschaltkreis zusammen mit der Kapazität $C_2$ bzw. $C_1 + C_2$ bildet, ist daher jedoch in den Schaltungen nach Fig. 2 und Fig. 3 im Wesentlichen gleich. Dies gilt insbesondere bei Gleichung 8. Die Arbeitspunkte der Schaltungen nach Fig. 2 und Fig. 3 sind nahezu identisch, da die Resonanzinduktivität in beiden Messungen im Wesentlichen die gleiche ist. Dies bedeutet insbesondere, dass die Arbeitspunkte der nichtlinearen Induktivität nahezu gleich sind, da die Impedanzwerte bei der Resonanzfrequenz der Messungen (mit $C_2$ bzw. $C_1 + C_2$) dicht beieinander sind. Gleichung 8 ist aufgrund desselben Arbeitspunkts die für die Bestimmung des Kapazitätsverhältnisses Kc gültige Gleichung.

Die Resonanzinduktivität L, welche zur getrennten Betrachtung der Kapazitäten der Kondensatoren $C_1$ und $C_2$ berücksichtigt werden kann, kann aus dem Typenschild abgeleitet werden. Die Resonanzinduktivität L kann die Kompensationsinduktivität $L_{comp}$, die Streuinduktivitäten $L_1$ und $L_2$ sowie die Hauptinduktivität $L_h$ darstellen. Beispielsweise kann die Resonanzinduktivität L mit der Thomsonschen Schwingungsgleichung nach Gleichung 10 bestimmt werden.

$$\text{Gleichung 10:} \qquad \omega^2 = \frac{1}{L * C} \rightarrow L = \frac{1}{\omega^2 * (C_1 + C_2)}$$

Beispielsweise kann die Resonanzinduktivität L des kapazitiven Spannungswandlers in Abhängigkeit von Nennwerten des ersten und zweiten Kondensators $C_1$ und $C_2$ und einer Nennfrequenz $\omega$ des kapazitiven Spannungswandlers bestimmt werden. Es ist jedoch zu beachten, dass die absoluten Werte der Induktivität, beispielsweise der Resonanzinduktivität L oder der Kompensationsinduktivität $L_{comp}$, sowie die absoluten Werte der Kondensatoren $C_1$ und $C_2$ nicht notwendigerweise bekannt sein müssen oder von großem Interesse sein müssen, da sie im allgemeinen eine gewisse Toleranz bezogen auf die Spezifikation auf dem Typenschild aufweisen. Interessanter ist der prozentuale Unterschied

der beiden Kapazitäten ($C_1$ und $C_2$) bei verschiedenen Messungen über der Zeit, also ein Trendverlauf des Verhältnisses der Kapazitäten zueinander. Daher ist es lediglich erforderlich, dass die gleiche Induktivität in den Gleichungen, welche den gleichen Arbeitspunkt aufweisen, verwendet wird. Eine Kenntnis des induktiven Übersetzungsverhältnisses des kapazitiven Spannungswandlers ist hierbei nicht erforderlich, d.h. sowohl das Kapazitätsverhältnis Kc als auch die Resonanzinduktivität L des kapazitiven Spannungswandlers können unter Verwendung der oben angegebenen Nennwerte von beispielsweise dem Typenschild unabhängig von dem induktiven Übersetzungsverhältnis bestimmt werden.

Resonanz wird in einem Schwingkreis erreicht, wenn der Phasenwinkel zwischen Strom und Spannung einen Phasenwinkel von 0° erreicht. Bei einem Phasenwinkel von 0° löschen sich induktive und kapazitive imaginäre Anteile gegenseitig aus und nur der Realteil bleibt übrig. Die Frequenz, bei welcher dies erreicht wird, wird als Resonanzfrequenz bezeichnet.

Alternativ oder zusätzlich kann die Resonanzinduktivität L des kapazitiven Spannungswandlers, welche für die Trennung von $C_1$ und $C_2$ von Bedeutung ist, aus frequenzabhängigen Kurzschlussimpedanzmessungen abgeleitet werden. Beispielsweise können mehrere Messungen der Kurzschlussimpedanz bei verschiedenen Frequenzen f über einen vorgegebenen Frequenzbereich durchgeführt werden. Die frequenzabhängigen Kurzschlussimpedanzmessungen können an der Sekundärseite des kapazitiven Spannungswandlers durchgeführt werden, während der Hochspannungsanschluss HV des ersten Kondensators $C_1$ mit Masse verbunden ist, wie es in Fig. 2 gezeigt ist. Alternativ oder zusätzlich können die frequenzabhängigen Kurzschlussimpedanzmessungen an der Sekundärseite des kapazitiven Spannungswandlers durchgeführt werden, während der Hochspannungsanschluss HV des ersten Kondensators $C_1$ offen ist, wie es in Fig. 3 gezeigt ist. Diese Messungen können als Messungen an einem Serienresonanzkreis aufgefasst werden. Aus den gemessenen Kurzschlussimpedanzen $Z_{sc}$ können eine minimale Impedanz $Z_{sc\_f0}$, eine Bandbreite B und eine Resonanzfrequenz $f_0$ bestimmt werden. Wie in Gleichung 11 gezeigt, wird die minimale Impedanz $Z_{sc\_f0}$ mittels der ersten Ableitung der Kurzschlussimpedanzen $Z_{sc}$ nach der Frequenz f bestimmt. Die minimale Impedanz $Z_{sc\_f0}$ liegt dort vor, wo die erste Ableitung der Kurzschlussimpedanz den Wert Null ergibt bzw. der Phasengang den Nulldurchgang hat. Dieser Punkt wird auch als Impedanz $Z_{sc\_f0}$ bei der Resonanzfrequenz $f_0$ bezeichnet. Diese Impedanz $Z_{sc\_f0}$ entspricht dem ohmschen Widerstand R, da sich die Imaginärteile gegenseitig aufheben. Die Bandbreite B ergibt sich ebenfalls aus den frequenzabhängigen Kurzschlussimpedanzmessungen. Die Bandbreite B ist über die -3dB-Punkte der Stromkurve definiert. Die Differenz zwischen der resultierenden oberen Grenzfrequenz $f_H$ und unteren Grenzfrequenz $f_L$ bei -3dB ist als Bandbreite B definiert, d.h. die Bandbreite B erstreckt sich über den Frequenzbereich von $f_L$ bis $f_H$, in dem der gemessene Kurzschlussstrom um maximal 3dB unter dem maximalen Kurzschlussstrom liegt. Die Impedanz bei den beiden Grenzfrequenzen $f_L$ und $f_H$ ist um den Faktor Wurzel 2 größer als die Impedanz $Z_{sc\_f0}$. Die Werte für die Resonanzinduktivität L" und Resonanzkapazität C" in Gleichung 12 beziehen sich auf die Sekundärseite des Transformators T und werden mit Hilfe des induktiven Übersetzungsverhältnisses $K_{IVT}$ des Transformators T auf die Primärseite übertragen, woraus sich die Resonanzinduktivität L' und die Resonanzkapazität C' auf der Primärseite des Spannungswandlers ergeben.

Gleichung 11:

$$\frac{dZ_{sc}}{df} = 0 \rightarrow Z_{sc\_f0} = R$$
$$B = f_H - f_L;\ Z_{sc\,(f_H\,und\,f_L)} = Z_{sc\_f0} \cdot \sqrt{2}$$

Gleichung 12:

$$L'' = \frac{f_0 \cdot R}{w_0 \cdot B} \rightarrow L' = L'' \cdot K_{IVT}^2$$

$$C'' = \frac{1}{w_0{}^2 * L''} \rightarrow C' = \frac{C''}{K_{IVT}^2}$$

Die so bestimmte Resonanzinduktivität L' auf der Primärseite entspricht der Resonanzinduktivität L, welche zur getrennten Betrachtung der Kapazitäten der Kondensatoren $C_1$ und $C_2$ berücksichtigt werden kann und welche die Kompensationsinduktivität $L_{comp}$, die Streuinduktivitäten $L_1$ und $L_2$ sowie die Hauptinduktivität $L_h$ in der jeweiligen Verschaltung gemäß Fig. 2 bzw. gemäß Fig. 3 darstellt.

Bei Durchführung der frequenzabhängigen Kurzschlussimpedanzmessungen bei Verschaltung des Hochspannungsanschlusses HV des ersten Kondensators $C_1$ mit Masse gemäß Fig. 2 entspricht die Resonanzkapazität C' der Summenkapazität des ersten und zweiten Kondensators $C_1$ und $C_2$. Die Resonanzfrequenz $f_0$ bzw. Resonanzkreisfrequenz $w_0$ entspricht der Resonanzfrequenz $\omega_e$ gemäß Gleichung 2 unter Berücksichtigung der entsprechenden Resonanzinduktivität L.

Bei Durchführung der frequenzabhängigen Kurzschlussimpedanzmessungen bei offenem Hochspannungsanschlusses HV des ersten Kondensators $C_1$ gemäß Fig. 3 entspricht die Resonanzkapazität C' der Kapazität des zweiten

Kondensators $C_2$. Die Resonanzfrequenz $f_0$ bzw. Resonanzkreisfrequenz $w_0$ entspricht der Resonanzfrequenz $\omega_2$ gemäß Gleichung 3 unter Berücksichtigung der entsprechenden Resonanzinduktivität L.

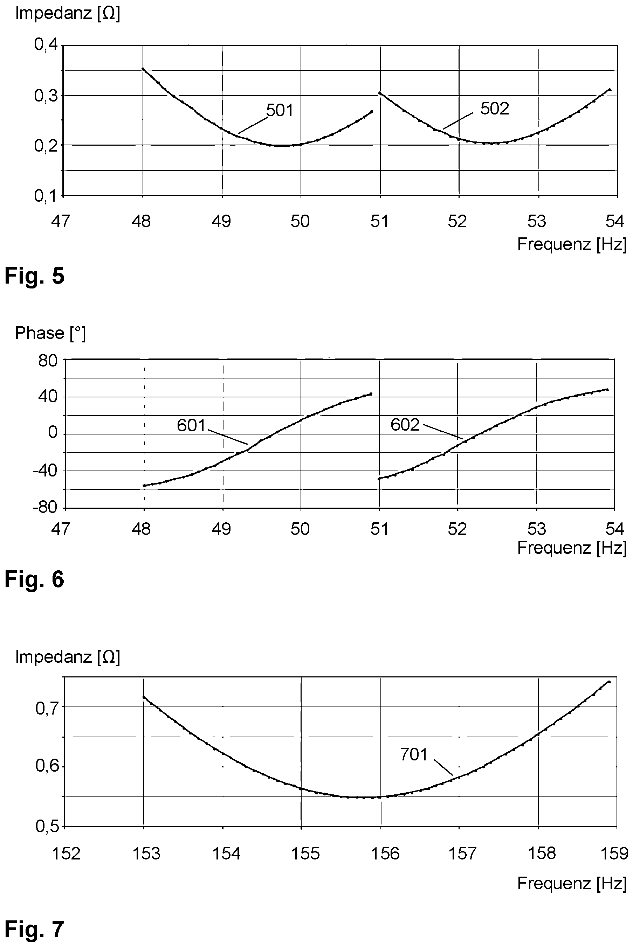

Fig. 5 zeigt Messergebnisse von Kurzschlussimpedanzmessungen bei unterschiedlichen Frequenzen. Im Detail zeigt Fig. 5 Impedanzen 501 von Kurzschlussimpedanzmessungen an dem kapazitiven Spannungswandler gemäß Fig. 2 bei unterschiedlichen Frequenzen und Impedanzen 502 von Kurzschlussimpedanzmessungen an dem kapazitiven Spannungswandler gemäß Fig. 3 bei unterschiedlichen Frequenzen. Fig. 6 zeigt entsprechende Phasenwinkel, welche bei den Kurzschlussimpedanzmessungen bei unterschiedlichen Frequenzen gemessen wurden. Phasenwinkel 601 wurden bei den Kurzschlussimpedanzmessungen an dem kapazitiven Spannungswandler gemäß Fig. 2 gemessen und Phasenwinkel 602 wurden bei den Kurzschlussimpedanzmessungen an dem kapazitiven Spannungswandler gemäß Fig. 3 gemessen. Die beiden Messungen zeigen einen sehr ähnlichen Verlauf von Impedanz und Phase als eine Funktion der Frequenz. Da sich die Kapazität $C_2$ nur wenig von der Gesamtkapazität $C_1$ plus $C_2$ unterscheidet und die Resonanzfrequenz ähnlich ist, kann angenommen werden, dass die gleiche Induktivität für das Resonanzphänomen in den Schaltungen des Spannungswandlers gemäß Fig. 2 und Fig. 3 verantwortlich ist. Die Resonanzfrequenz des kapazitiven Spannungswandlers in der Beschaltung gemäß Fig. 2 liegt in diesem Beispiel zwischen 49 und 50 Hz und die Resonanzfrequenz des kapazitiven Spannungswandlers in der Beschaltung gemäß Fig. 3 liegt in diesem Beispiel zwischen 52 und 53 Hz.

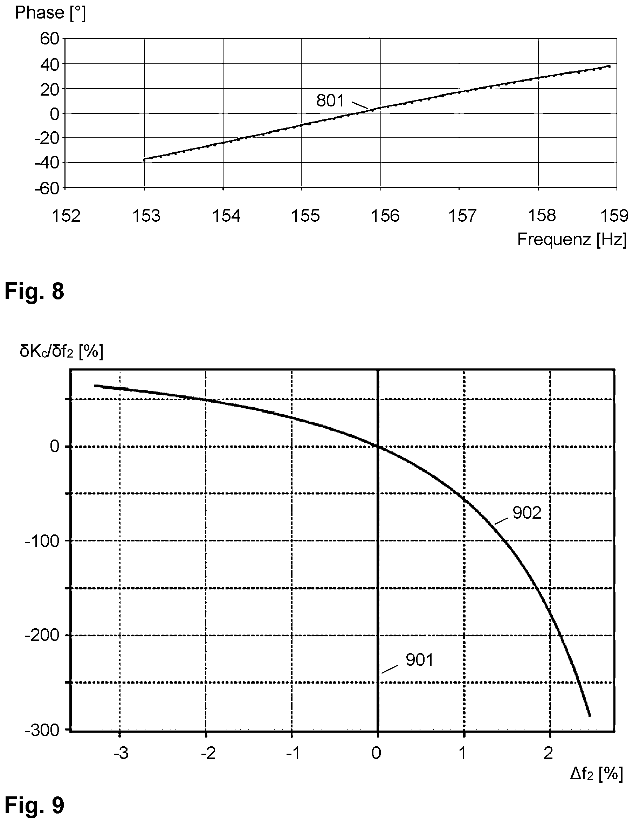

Wie weiter oben beschrieben wurde, ist insbesondere Gleichung 8 für die Betrachtung des Kapazitätsverhältnisses des kapazitiven Spannungsteilers geeignet, da die Arbeitspunkte der Schaltungen nach Fig. 2 und Fig. 3 nahezu identisch sind, sodass auch die Arbeitspunkte der nichtlinearen Anteile der Induktivitäten nahezu gleich sind. Im Gegensatz dazu liegt die Resonanzfrequenz der Beschaltung des kapazitiven Spannungswandlers gemäß Fig. 4 in einem deutlich anderen Bereich, wie die Messergebnisse der Figuren 7 und 8 zeigen. Fig. 7 zeigt die Impedanz 701 von Kurzschlussimpedanzmessungen an dem kapazitiven Spannungswandler gemäß Fig. 4 bei unterschiedlichen Frequenzen und Fig. 8 zeigt entsprechende Phasenwinkel 801, welche bei den Kurzschlussimpedanzmessungen bei unterschiedlichen Frequenzen gemessen wurden. Aus den Figuren 7 und 8 ist ersichtlich, dass die Resonanzfrequenz des kapazitiven Spannungswandlers in der Beschaltung gemäß Fig. 4 im Bereich von 155 bis 156 Hz liegt.

Die Kurzschlussimpedanzmessungen an dem kapazitiven Spannungswandler gemäß der Beschaltungen, wie sie in den Figuren 2 und 3 gezeigt sind, sind daher zum einen möglich, ohne die Masseverbindung an dem Anschluss NHF zu trennen, und können ferner sicherstellen, dass der kapazitiven Spannungswandler in beiden Fällen in einem näherungsweise gleichen Arbeitspunkt betrieben wird, sodass ein nichtlineares Verhalten von Komponenten des kapazitiven Spannungswandlers, beispielsweise Induktivitäten in dem kapazitiven Spannungswandler, vernachlässigt werden kann.

Die nachfolgenden Betrachtungen beruhen auf mindestens zwei Resonanzfrequenzen von unterschiedlichen Messungen, beispielsweise Kurzschlussimpedanzmessungen gemäß der Beschaltungen, wie sie in den Figuren 2 und 3 gezeigt sind. Die Resonanzfrequenzen können aus Messergebnissen der Kurzschlussimpedanzmessungen abgeleitet werden, beispielsweise durch Interpolation. Die Interpolation kann eine gewisse Ungenauigkeit aufweisen. Um dieser Ungenauigkeit entgegenzuwirken, können mehrere Messungen um den Phasennulldurchgang durchgeführt werden. Beispielsweise kann in einem ersten Messdurchlauf ein verhältnismäßig breiter Frequenzbereich in weiten Frequenzschritten abgetastet werden, beispielsweise ein Frequenzbereich von 20 Hz bis 200 Hz in Schritten von wenigen Hertz, beispielsweise in Schritten von 0,5 Hz bis 5 Hz. Dadurch kann ein ungefährer Bereich, in dem sich die Resonanzfrequenz befindet, festgestellt werden. Der ungefähre Bereich umfasst nur noch wenige Hertz. In einem zweiten Messdurchlauf kann dieser Bereich in kleineren Frequenzschritten abgetastet werden, beispielsweise in Schritten von 0,1 Hz oder 0,01 Hz, um die Resonanzfrequenz genauer zu bestimmen.

Unter Verwendung der Gleichung 8 kann das Kapazitätsverhältnis basierend auf den mittels der Kurzschlussimpedanzmessungen bestimmten Resonanzfrequenzen bestimmt werden, beispielsweise auf der Grundlage der für die Schaltungen nach Fig. 2 und Fig. 3 bestimmten Resonanzfrequenzen $\omega_e$ und $\omega_2$:

$$\text{Gleichung 13:} \qquad K_c = \frac{\omega_2^2}{\omega_2^2 - \omega_e^2}$$

Das Kapazitätsverhältnis Kc kann beispielsweise in einem Bereich von 10 liegen.

Basierend auf dem Kapazitätsverhältnis Kc können beispielsweise die absoluten Werte der Kapazitäten der Kondensatoren $C_1$ und $C_2$ bestimmt werden. Zunächst ist dazu die gesamte Induktivität des kapazitiven Spannungswandlers zu bestimmen. Dazu können die Kapazitätswerte von dem Typenschild des Spannungswandlers verwendet werden. Auf dem Typenschild des kapazitiven Spannungswandlers können beispielsweise Kapazitätswerte für $C_1$ und $C_2$ angegeben sein. Typische Werte sind beispielsweise $C_1$ = 5140 pF (+10%, -5%) und $C_2$ = 50700 pF (+10%, - 5%). Ferner kann die Nennfrequenz des kapazitiven Spannungswandlers angegeben sein, beispielsweise 50 Hz. Diese Werte können in die nachfolgende Gleichung 14 eingesetzt werden, woraus die Induktivität des kapazitiven Spannungswandlers zumindest näherungsweise bestimmt werden kann. Für das zuvor genannte Beispiel beträgt die Induktivität beispielsweise 180,1586 H.

$$\text{Gleichung 14:} \qquad \omega^2 = \frac{1}{L*C} \rightarrow L = \frac{1}{\omega^2*(C_1+C_2)}$$

Die tatsächliche Kapazität des Kondensators $C_2$ kann dann unter Verwendung der Gleichung 15 unter Verwendung der Resonanzfrequenz $\omega_2$ bestimmt werden.

$$\text{Gleichung 15:} \qquad C_2 = \frac{1}{L*\omega_2^2}$$

Die Kapazität des Kondensators $C_1$ kann unter Verwendung der Kapazität des Kondensators $C_2$ und des Kapazitätsverhältnisses Kc gemäß der Gleichung 16 bestimmt werden.

$$\text{Gleichung 16:} \qquad C_1 = \frac{C_2}{K_c-1}$$

Die Abweichungen der so bestimmten Kapazitäten der Kondensatoren $C_1$ und $C_2$ von den auf dem Typenschild angegebenen Werten können absolut oder relativ bestimmt werden und zur Beurteilung des Zustands des kapazitiven Spannungsteilers auf einer Anzeigevorrichtung des Messgeräts 90 angezeigt werden. Ein zuverlässiger Betrieb des kapazitiven Spannungswandlers kann beispielsweise angenommen werden, wenn die tatsächlich bestimmten Kapazitäten der Kondensatoren $C_1$ und $C_2$ innerhalb der auf dem Typenschild angegebenen Toleranzbereiche liegen.

Weiterhin kann eine Abhängigkeit des Kapazitätsverhältnisses von der Resonanzfrequenz $\omega_e$ oder von der Resonanzfrequenz $\omega_2$ bestimmt und für eine Beurteilung des Zustands der Kondensatoren des kapazitiven Spannungsteilers angezeigt werden. Durch partielles Differenzieren der Gleichung 8 nach der Resonanzfrequenz $\omega_2$ kann die Abhängigkeit des Kapazitätsverhältnisses Kc von der Resonanzfrequenz $\omega_2$ gemäß Gleichung 17 bestimmt werden.

$$\text{Gleichung 17:} \qquad \frac{\delta K_C}{\delta \omega_2} = -\frac{2*\omega_2*\omega_e^2}{\left(\omega_2^2-\omega_e^2\right)^2}$$

Ebenso kann durch partielles differenzieren der Gleichung 8 nach der Resonanzfrequenz $\omega_e$ die Abhängigkeit des Kapazitätsverhältnisses Kc von der Resonanzfrequenz $\omega_e$ gemäß Gleichung 18 bestimmt werden.

$$\text{Gleichung 18:} \qquad \frac{\delta K_C}{\delta \omega_e} = \frac{2*\omega_2^2*\omega_e}{\left(\omega_2^2-\omega_e^2\right)^2}$$

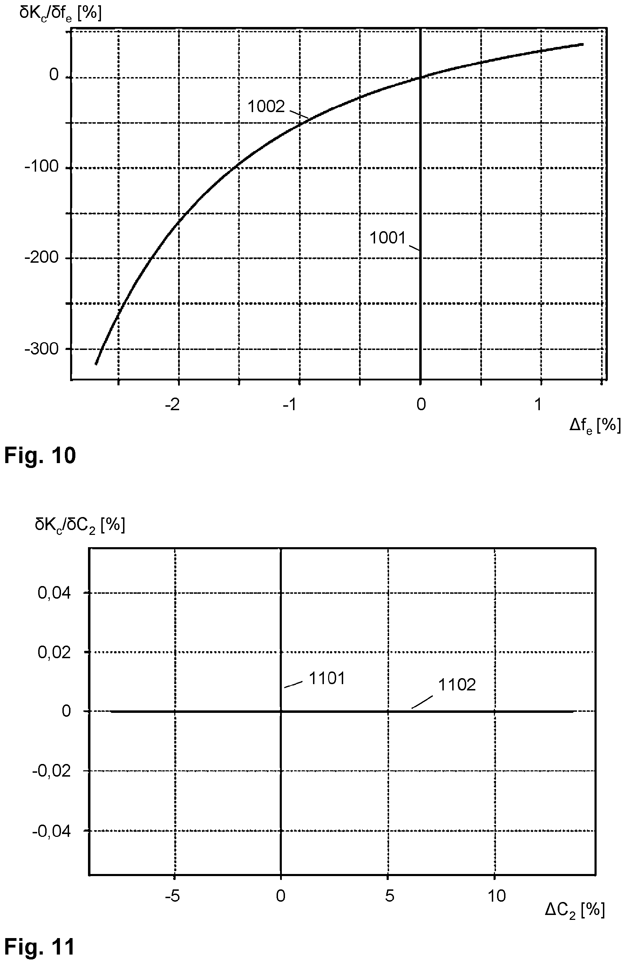

Die Abhängigkeit des Kapazitätsverhältnisses von der Resonanzfrequenz $\omega_e$ bzw. $\omega_2$ betrifft somit eine Abhängigkeit der Änderung des Kapazitätsverhältnisses bezogen auf eine Änderung der Resonanzfrequenz $\omega_e$ bzw. $\omega_2$. Diese Abhängigkeit wird auch als Empfindlichkeit oder Sensitivität bezeichnet. Eine hohe Empfindlichkeit kann dazu beitragen, dass auch kleine Änderungen deutlich erkannt werden können und somit eine Zustandsverschlechterung des kapazitiven Spannungsteilers frühzeitig und zuverlässig erkannt werden kann. Fig. 9 zeigt die Empfindlichkeit des Kapazitätsverhältnisses Kc bezogen auf eine Änderung der Resonanzfrequenz $\omega_2$, wobei die Darstellung auf die gemessene Resonanzfrequenz normiert wurde, das heißt, die gemessene Resonanzfrequenz wird durch die Linie 901 dargestellt und die Empfindlichkeit des Kapazitätsverhältnisses durch den Graph 902 in Prozent in Abhängigkeit der Resonanzfrequenzänderung in Prozent. Fig. 10 zeigt die Empfindlichkeit des Kapazitätsverhältnisses Kc bezogen auf eine Änderung der Resonanzfrequenz $\omega_e$. Auch diese Darstellung wurde auf die gemessene Resonanzfrequenz normiert, das heißt, die gemessene Resonanzfrequenz wird durch die Linie 1001 dargestellt und die Empfindlichkeit des Kapazitätsverhältnisses durch den Graph 1002 in Prozent in Abhängigkeit von der Resonanzfrequenzänderung in Prozent.

Basierend auf Gleichung 5 kann die Abhängigkeit bzw. Empfindlichkeit des Kapazitätsverhältnisses Kc von der Kapazität des Kondensators $C_2$ gemäß Gleichung 19 dargestellt werden. Aus Gleichung 19 ist ersichtlich, dass die Empfindlichkeit des Kapazitätsverhältnisses Kc auch bei einer Änderung der Kapazität des Kondensators $C_2$ konstant ist.

Gleichung 19: $\quad \dfrac{\delta K_C}{\delta C_2} = \dfrac{1}{C_1}$

Ebenso kann basierend auf Gleichung 5 die Abhängigkeit beziehungsweise Empfindlichkeit des Kapazitätsverhältnisses Kc von der Kapazität des Kondensators $C_1$ gemäß Gleichung 20 dargestellt werden.

Gleichung 20: $\quad \dfrac{\delta K_C}{\delta C_1} = -\dfrac{C_2}{C_1^2}$

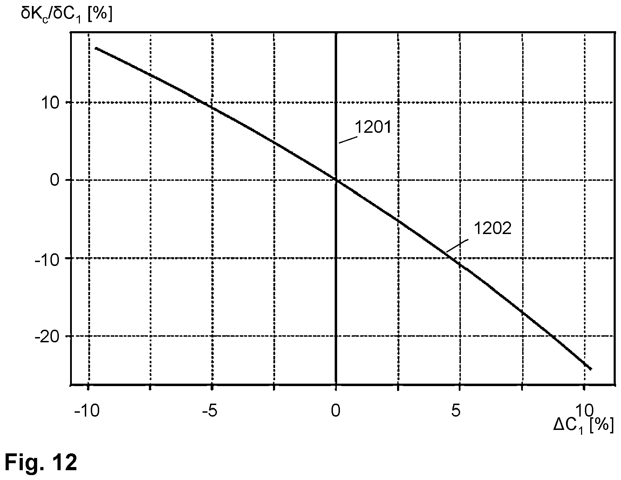

Fig. 11 zeigt die Empfindlichkeit des Kapazitätsverhältnisses Kc bezogen auf eine Änderung der Kapazität des Kondensators $C_2$. Die Darstellung wurde auf die gemessene Resonanzfrequenz normiert, das heißt, die gemessene Resonanzfrequenz wird durch die Linie 1101 dargestellt und die Empfindlichkeit des Kapazitätsverhältnisses durch den Graph 1102 in Prozent in Abhängigkeit der Änderung der Kapazität des Kondensators $C_2$ in Prozent. Fig. 12 zeigt entsprechend die Empfindlichkeit des Kapazitätsverhältnisses Kc bezogen auf eine Änderung der Kapazität des Kondensators $C_2$, wobei die Darstellung auf die gemessene Resonanzfrequenz normiert wurde. Die gemessene Resonanzfrequenz wird durch die Linie 1201 dargestellt und die Empfindlichkeit des Kapazitätsverhältnisses durch den Graph 1202 in Prozent in Abhängigkeit der Änderung der Kapazität des Kondensators $C_1$ in Prozent.

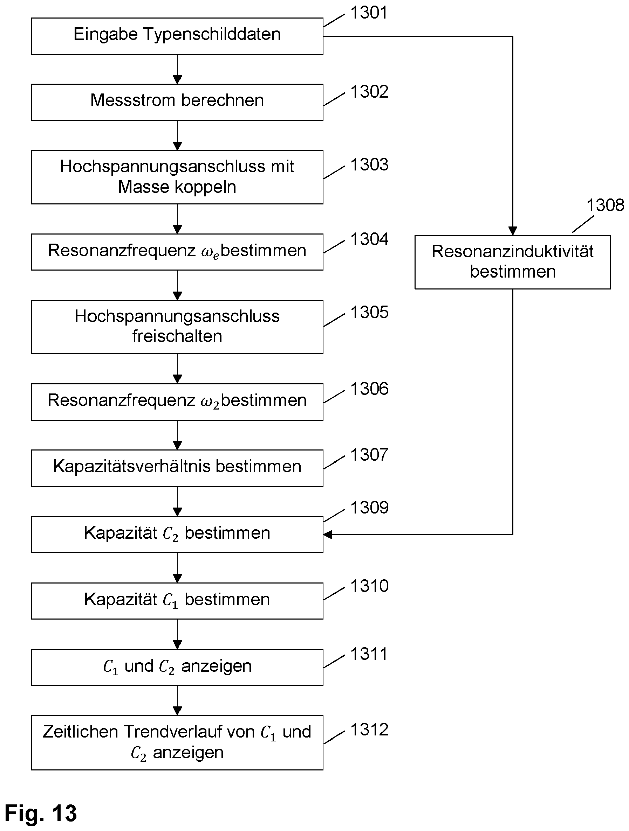

Das zuvor bestimmte Verfahren kann von dem Messgerät 90 automatisch durchgeführt werden. Die Arbeitsweise des Messgeräts 90 wird nachfolgend zusammenfassend unter Bezugnahme auf die Figuren 13 bis 15 beschrieben.

Das in Fig. 13 gezeigte Verfahren umfasst Verfahrensschritte 1301 bis 1312. Im Schritt 1301 werden Daten des Typenschilds des kapazitiven Spannungswandlers eingegeben, beispielsweise über eine Benutzerschnittstelle von einer Bedienperson des Messgeräts 90 oder mit einem entsprechenden Scanner, welcher das Typenschild des zu prüfenden kapazitiven Spannungswandlers abtastet. Die Daten des Typenschilds können beispielsweise die Bürde und den Spannungsabfall an der Bürde bei Nennfrequenz sowie Nennwerte des ersten und zweiten Kondensators umfassen. Obwohl die nachfolgend beschriebenen Kurzschlussimpedanzmessungen an einer Sekundärseite eines Transformators des kapazitiven Spannungswandlers durchgeführt werden, ist eine Kenntnis eines induktiven Übersetzungsverhältnisses des Transformators bei diesem Verfahren nicht erforderlich. Anhand der Daten des Typenschilds wird im Schritt 1302 ein Messstrom berechnet, beispielsweise wie zuvor beschrieben unter Verwendung der Bürde und des Spannungsabfalls an der Bürde bei Nennfrequenz. Im Schritt 1303 wird der Hochspannungsanschluss HV von der Hochspannungsleitung 60 entkoppelt und mit Masse 70 gekoppelt, sodass die Beschaltung gemäß Fig. 2 vorliegt. Im Schritt 1304 wird die Resonanzfrequenz $\omega_e$ bestimmt, beispielsweise mittels mehrerer Kurzschlussimpedanzmessungen in einem ersten Frequenzraster gefolgt von mehreren Kurzschlussimpedanzmessungen in einem zweiten Frequenzraster, wobei das erste Frequenzraster einen größeren Frequenzabstand als das zweite Frequenzraster aufweist. Im Schritt 1305 wird der Hochspannungsanschluss HV freigeschaltet, sodass die Beschaltung gemäß Fig. 3 vorliegt. Im Schritt 1306 wird die Resonanzfrequenz $\omega_2$ mittels Kurzschlussimpedanzmessungen bestimmt. Wiederum können dazu mehreren Kurzschlussimpedanzmessungen in einem ersten Frequenzraster gefolgt von mehreren Kurzschlussimpedanzmessungen in einem zweiten Frequenzraster durchgeführt werden, wobei das erste Frequenzraster einen größeren Frequenzabstand als das zweite Frequenzraster aufweist. Im Schritt 1307 wird ein Kapazitätsverhältnis Kc beispielsweise gemäß Gleichung 8 bestimmt. Im Schritt 1308 wird aus den Daten des Typenschilds die Resonanzinduktivität L bestimmt, wie es zuvor unter Bezugnahme auf Gleichungen 10 und 14 beschrieben wurde. Im Schritt 1309 kann unter Berücksichtigung der Resonanzinduktivität L die Kapazität des Kondensators $C_2$ gemäß Gleichung 15 bestimmt werden und im Schritt 1310 die Kapazität des Kondensators $C_1$ gemäß Gleichung 16. Im Schritt 1311 werden die Kapazitätswerte der Kondensatoren $C_1$ und $C_2$ auf beispielsweise einer Anzeigevorrichtung des Messgeräts 90 angezeigt. Darüber hinaus kann im Schritt 1312 ein zeitlicher Trendverlauf der Kapazitäten der Kondensatoren $C_1$ und $C_2$ auf der Anzeigevorrichtung angezeigt werden oder beispielsweise in einer Verarbeitungsvorrichtung über einen längeren Zeitraum aufgezeichnet und ausgewertet werden. Für eine Trendanalyse können die Kapazitäten der Kondensatoren $C_1$ und $C_2$ über einen längeren Zeitraum erfasst und beispielsweise in einen Cloud-Speicher übertragen werden.

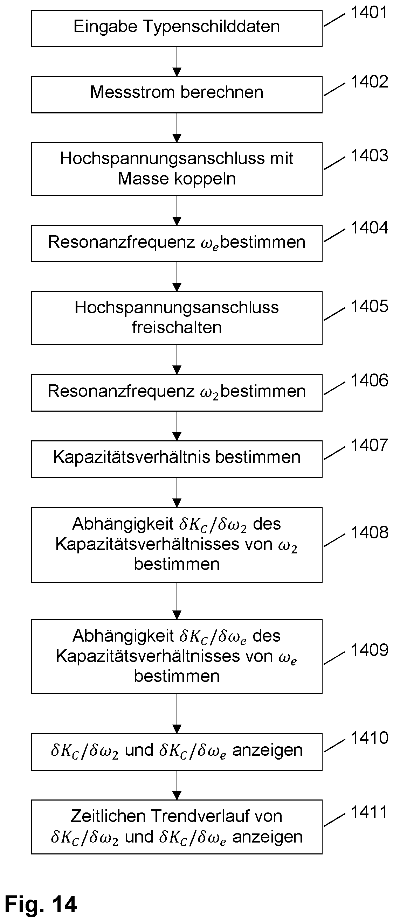

Das in Fig. 14 gezeigte Verfahren umfasst Verfahrensschritte 1401 bis 1411. Im Schritt 1401 werden Daten des Typenschilds des kapazitiven Spannungswandlers eingegeben. Diese Daten können beispielsweise über eine Benutzerschnittstelle von einer Bedienperson des Messgeräts 90 eingegeben werden. Alternativ können diese Daten elektronisch von dem Typenschild des zu prüfenden kapazitiven Spannungswandlers erfasst werden, beispielsweise mittels eines Scanners oder einer Kamera. Die Daten des Typenschilds können beispielsweise die Bürde und den Spannungsabfall an der Bürde bei Nennfrequenz umfassen. Obwohl die nachfolgend beschriebenen Kurzschlussimpedanzmessungen an einer Sekundärseite eines Transformators des kapazitiven Spannungswandlers durchgeführt werden, ist eine Kenntnis eines induktiven Übersetzungsverhältnisses des Transformators bei diesem Verfahren nicht erforderlich. Anhand der Daten des Typenschilds kann im Schritt 1402 ein geeigneter Messstrom berechnet werden (vergleiche Schritt 1302). Im Schritt 1403 wird der Hochspannungsanschluss HV von der Hochspannungsleitung 60 entkoppelt und mit Masse 70 gekoppelt. Es liegt somit die Beschaltung des kapazitiven Spannungswandlers gemäß Fig. 2 vor. Als nächstes wird im Schritt 1404 die Resonanzfrequenz $\omega_e$ bestimmt, beispielsweise wie zuvor beschrieben unter Verwendung zweier Durchläufe von jeweils mehreren Kurzschlussimpedanzmessungen in unterschiedlichen Frequenzrastern. Im Schritt 1405 wird der Hochspannungsanschluss HV freigeschaltet, sodass die Beschaltung des kapazitiven Spannungswandlers nach Fig. 3 vorliegt. Im Schritt 1406 wird die Resonanzfrequenz $\omega_2$ bestimmt, beispielsweise ebenfalls wie zuvor beschrieben unter Verwendung zweier Durchläufe von jeweils mehreren Kurzschlussimpedanzmessungen mit unterschiedlichen Frequenzrastern. Im Schritt 1407 wird ein Kapazitätsverhältnis Kc beispielsweise gemäß Gleichung 8 bestimmt. Im Schritt 1408 wird eine Abhängigkeit oder Sensitivität des Kapazitätsverhältnisses bezogen auf die Resonanzfrequenz $\omega_2$ bestimmt (siehe auch Gleichung 17). Im Schritt 1409 wird eine Abhängigkeit oder Sensitivität des Kapazitätsverhältnisses bezogen auf die Resonanzfrequenz $\omega_e$ bestimmt (siehe auch Gleichung 18). Die Sensitivitäten des Kapazitätsverhältnisses bezogen auf die Resonanzfrequenz $\omega_2$ bzw. $\omega_e$ werden im Schritt 1410 auf einer Anzeigevorrichtung des Messgeräts 90 angezeigt. Zusätzlich können im Schritt 1411 zeitliche Trendverläufe der Sensitivitäten des Kapazitätsverhältnisses bezogen auf die Resonanzfrequenz $\omega_2$ bzw. $\omega$ die über der Zeit angezeigt werden oder gespeichert werden, um von einer Verarbeitungsvorrichtung ausgewertet zu werden. Für eine Trendanalyse können die Sensitivitäten über einen längeren Zeitraum erfasst werden und beispielsweise in einen Cloud-Speicher übertragen werden.

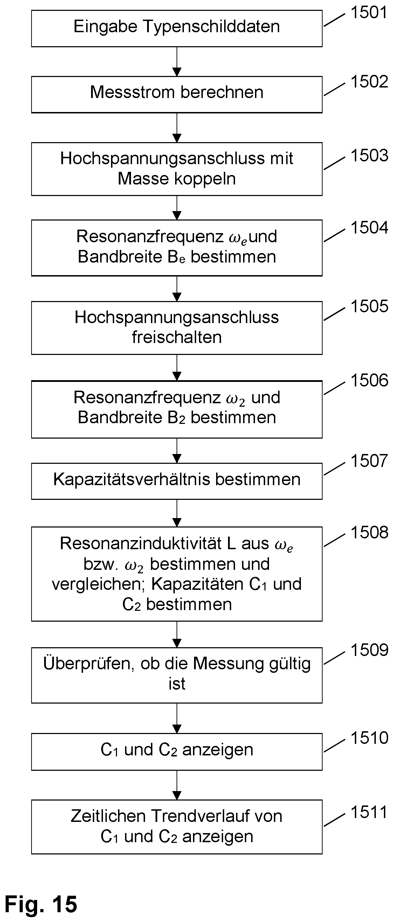

Das in Fig. 15 gezeigte Verfahren umfasst Verfahrensschritte 1501 bis 1511. Im Schritt 1501 werden Daten des Typenschilds des kapazitiven Spannungswandler eingegeben. Diese Daten können beispielsweise über eine Benutzerschnittstelle von einer Bedienperson des Messgeräts 90 eingegeben werden. Alternativ können diese Daten elektronisch von dem Typenschild des zu prüfenden kapazitiven Spannungswandlers erfasst werden, beispielsweise mittels eines Scanners oder einer Kamera. Die Daten des Typenschilds können beispielsweise die Bürde und den Spannungsabfall an der Bürde bei Nennfrequenz sowie ein induktives Übersetzungsverhältnis eines Transformators des kapazitiven Spannungswandlers umfassen. Anhand der Daten des Typenschilds kann im Schritt 1502 ein geeigneter Messstrom berechnet werden (vergleiche Schritt 1302). Im Schritt 1503 wird der Hochspannungsanschluss HV von der Hochspannungsleitung 60 entkoppelt und mit Masse 70 gekoppelt. Es liegt somit die Beschaltung des kapazitiven Spannungswandlers gemäß Fig. 2 vor. Als nächstes wird im Schritt 1504 die Resonanzfrequenz $\omega_e$ und Bandbreite $B_e$ bestimmt (siehe auch Gleichung 11), beispielsweise wie zuvor beschrieben unter Verwendung zweier Durchläufe von jeweils mehreren Kurzschlussimpedanzmessungen in unterschiedlichen Frequenzrastern. Im Schritt 1505 wird der Hochspannungsanschluss HV freigeschaltet, sodass die Beschaltung des kapazitiven Spannungswandlers nach Fig. 3 vorliegt. Im Schritt 1506 wird die Resonanzfrequenz $\omega_2$ und Bandbreite $B_2$ bestimmt (siehe auch Gleichung 11), beispielsweise ebenfalls wie zuvor beschrieben unter Verwendung zweier Durchläufe von jeweils mehreren Kurzschlussimpedanzmessungen mit unterschiedlichen Frequenzrastern. Im Schritt 1507 wird ein Kapazitätsverhältnis Kc beispielsweise gemäß Gleichung 8 aus den Resonanzfrequenzen $\omega_e$ und $\omega_2$ bestimmt. Im Schritt 1508 wird eine jeweilige Resonanzinduktivität L aus der Resonanzfrequenz $\omega_e$ bzw. $\omega_2$ bestimmt (siehe auch Gleichung 12). Ferner können im Schritt 1508 unter Verwendung der jeweiligen Resonanzinduktivität L, der jeweiligen Resonanzfrequenz $\omega_e$ bzw. $\omega_2$ und dem induktiven Übersetzungsverhältnis die Summenkapazität der Kondensatoren $C_1$ und $C_2$ bzw. die Kapazität des Kondensators $C_2$ gemäß Gleichung 12 bestimmt werden. Daraus kann wiederum die Kapazität des Kondensators $C_1$ bestimmt werden. Im Schritt 1509 kann überprüft werden, ob die Messung gültig ist, indem das im Schritt 1507 bestimmte Kapazitätsverhältnis Kc mit dem Kapazitätsverhältnis der im Schritt 1508 bestimmten Kapazitäten der Kondensatoren $C_1$ und $C_2$ übereinstimmt. Sofern die Messung gültig ist, können im Schritt 1510 die Kapazitätswerte der Kondensatoren $C_1$ und $C_2$ auf beispielsweise einer Anzeigevorrichtung des Messgeräts 90 angezeigt. Darüber hinaus kann im Schritt 1511 ein zeitlicher Trendverlauf der Kapazitäten der Kondensatoren $C_1$ und $C_2$ auf der Anzeigevorrichtung angezeigt werden oder beispielsweise in einer Verarbeitungsvorrichtung über einen längeren Zeitraum aufgezeichnet und ausgewertet werden. Für eine Trendanalyse können die Kapazitäten der Kondensatoren $C_1$ und $C_2$ über einen längeren Zeitraum erfasst und beispielsweise in einen Cloud-Speicher übertragen werden.

Zusammenfassend stellen die zuvor beschriebenen Verfahren eine Möglichkeit bereit, einen Trendverlauf der beiden Kapazitäten eines kapazitiven Spannungsteilers in einem kapazitiven Spannungswandler zu bestimmen und zu beobachten, um einen Zustand des kapazitiven Spannungswandlers zu beurteilen. Der Trendverlauf stellt eine Information über den zeitlichen Trend der Kapazitäten der Kondensatoren $C_1$ und $C_2$ in dem kapazitiven Spannungsteiler bereit. Für eine Trendanalyse der Kapazitäten ist eine zeitliche Änderung über der Zeit aussagekräftiger als der absolute Wert der Kapazitäten. Daher ist es gerechtfertigt, die Kapazitätswerte von dem Typenschild zu verwenden, um die Induktivität L des kapazitiven Spannungswandlers zu bestimmen, da die absolute Genauigkeit der Kapazitätswerte der Kondensatoren $C_1$ und $C_2$ nicht entscheidend für den Trendverlauf der beiden Kapazitäten ist. Basierend auf der so erhaltenen Induktivität L und den mittels Kurzschlussimpedanzmessungen bestimmten Resonanzfrequenzen $\omega_e$ und $\omega_2$ können die Kapazitäten der Kondensatoren $C_1$ und $C_2$ berechnet und als Referenzwerte verwendet werden. Diese Werte stellen eine zuverlässige Basis für eine Zustandsüberwachung mittels eines Trendverlaufs bereit.

**Patentansprüche**

1.  Verfahren zum Bestimmen eines Zustands eines kapazitiven Spannungswandlers, wobei der kapazitive Spannungswandler (50) an seiner Primärseite einen kapazitiven Spannungsteiler mit einem ersten Kondensator ($C_1$) und einem zweiten Kondensator ($C_2$) umfasst, wobei der erste Kondensator ($C_1$) einen Hochspannungsanschluss (HV) zum Verbinden mit einer Hochspannung (60) aufweist und der zweite Kondensator ($C_2$) einen Masseanschluss (NHF) aufweist, wobei das Verfahren **gekennzeichnet ist durch**:

    - Bestimmen einer ersten Resonanzfrequenz ($\omega_e$) mittels mehrerer erster Kurzschlussimpedanzmessungen bei verschiedenen Frequenzen an einer Sekundärseite des kapazitiven Spannungswandler (50), während der Hochspannungsanschluss (HV) mit Masse (70) verbunden ist,
    - Bestimmen einer zweiten Resonanzfrequenz ($\omega_2$) mittels mehrerer zweiter Kurzschlussimpedanzmessungen bei verschiedenen Frequenzen an der Sekundärseite des kapazitiven Spannungswandlers (50), während der Hochspannungsanschluss (HV) offen ist, und
    - Bestimmen eines Kapazitätsverhältnisses (Kc) des kapazitiven Spannungsteilers (50) in Abhängigkeit von der ersten Resonanzfrequenz ($\omega_e$) und der zweiten Resonanzfrequenz ($\omega_2$).

2.  Verfahren nach Anspruch 1, ferner umfassend:

    - Bestimmen eines Messstroms in Abhängigkeit von einer Bürde des kapazitiven Spannungswandlers (50) und einem Spannungsabfall an der Bürde des kapazitiven Spannungswandlers (50), wobei die mehreren ersten Kurzschlussimpedanzmessungen und die mehreren zweiten Kurzschlussimpedanzmessungen unter Verwendung des Messstroms durchgeführt werden.

3.  Verfahren nach Anspruch 1 oder Anspruch 2,

    wobei die mehreren ersten Kurzschlussimpedanzmessungen mehrere Kurzschlussimpedanzmessungen in einem ersten Frequenzraster gefolgt von mehreren Kurzschlussimpedanzmessungen in einem zweiten Frequenzraster umfassen, wobei das erste Frequenzraster einen größeren Frequenzabstand als das zweite Frequenzraster aufweist, und/oder
    wobei die mehreren zweiten Kurzschlussimpedanzmessungen mehrere Kurzschlussimpedanzmessungen in einem ersten Frequenzraster gefolgt von mehreren Kurzschlussimpedanzmessungen in einem zweiten Frequenzraster umfassen, wobei das erste Frequenzraster einen größeren Frequenzabstand als das zweite Frequenzraster aufweist.

4.  Verfahren nach einem der vorhergehenden Ansprüche, ferner umfassend:

    - Bestimmen einer Resonanzinduktivität des kapazitiven Spannungswandlers (50) in Abhängigkeit von Nennwerten des ersten und zweiten Kondensators ($C_1$, $C_2$) und einer Nennfrequenz des kapazitiven Spannungswandlers (50), und
    - Bestimmen eines Istwerts der Kapazität des zweiten Kondensators ($C_2$) in Abhängigkeit von der zweiten Resonanzfrequenz ($\omega_2$) und der Resonanzinduktivität.

5.  Verfahren nach Anspruch 4, wobei die Resonanzinduktivität unabhängig von einem induktiven Übersetzungsverhältnis eines Transformators des kapazitiven Spannungswandlers bestimmt wird.

6.  Verfahren nach einem der vorhergehenden Ansprüche, ferner umfassend:

    - Bestimmen einer ersten minimalen Impedanz und einer ersten Bandbreite mittels der mehreren ersten Kurzschlussimpedanzmessungen bei verschiedenen Frequenzen an der Sekundärseite des kapazitiven Spannungswandler (50), während der Hochspannungsanschluss (HV) mit Masse (70) verbunden ist,
    - Bestimmen einer zweiten minimalen Impedanz und einer zweiten Bandbreite mittels der mehreren zweiten Kurzschlussimpedanzmessungen bei verschiedenen Frequenzen an der Sekundärseite des kapazitiven Spannungswandlers (50), während der Hochspannungsanschluss (HV) offen ist, und
    - Bestimmen eines Istwerts der Kapazität des ersten Kondensators $C_1$ und eines Istwerts der Kapazität des zweiten Kondensators $C_2$ in Abhängigkeit von der ersten minimalen Impedanz, der ersten Bandbreite, der zweiten minimalen Impedanz der zweiten Bandbreite und einem induktiven Übersetzungsverhältnis eines Transformators des kapazitiven Spannungswandlers.

7. Verfahren nach Anspruch 6, ferner umfassend:

    - Vergleichen des Kapazitätsverhältnisses (Kc), welches in Abhängigkeit von der ersten Resonanzfrequenz ($\omega_e$) und der zweiten Resonanzfrequenz ($\omega_2$) bestimmt wird, mit einem Kapazitätsverhältnis, welches in Abhängigkeit von dem Istwert der Kapazität des ersten Kondensators $C_1$ und dem Istwert der Kapazität des zweiten Kondensators $C_2$ bestimmt wird, und
    - Bestimmen einer Gültigkeit der Bestimmung des Istwerts der Kapazität des ersten Kondensators $C_1$ und des Istwerts der Kapazität des zweiten Kondensators $C_2$ in Abhängigkeit von dem Vergleich.

8. Verfahren nach einem der Ansprüche 4 bis 7, ferner umfassend:

    - Bestimmen mehrere Istwerte der Kapazität des zweiten Kondensators ($C_2$) zu unterschiedlichen Zeitpunkten, und
    - Darstellen eines zeitlichen Trendverlaufs der Kapazität des zweiten Kondensators ($C_2$) auf einer Anzeigevorrichtung.

9. Verfahren nach Anspruch 4 oder Anspruch 5, ferner umfassend:

    - Bestimmen eines Istwerts der Kapazität des ersten Kondensators ($C_1$) in Abhängigkeit von dem Istwert der Kapazität des zweiten Kondensators ($C_2$) und dem Kapazitätsverhältnis (Kc).

10. Verfahren nach einem der Ansprüche 6 bis 9, ferner umfassend:

    - Bestimmen mehrere Istwerte der Kapazität des ersten Kondensators ($C_1$) zu unterschiedlichen Zeitpunkten, und
    - Darstellen eines zeitlichen Trendverlaufs der Kapazität des ersten Kondensators ($C_1$) auf einer Anzeigevorrichtung.

11. Verfahren nach einem der vorhergehenden Ansprüche, ferner umfassend:

    - Bestimmen mehrerer Kapazitätsverhältnisse (Kc) des kapazitiven Spannungsteilers zu unterschiedlichen Zeitpunkten, und
    - Darstellen eines zeitlichen Trendverlaufs des Kapazitätsverhältnisses (Kc) auf einer Anzeigevorrichtung.

12. Verfahren nach einem der vorhergehenden Ansprüche, ferner umfassend:

    - Bestimmen einer ersten Abhängigkeit ($\delta K_C/\delta\omega_e$) des Kapazitätsverhältnisses (Kc) von der ersten Resonanzfrequenz ($\omega_e$).

13. Verfahren nach einem der vorhergehenden Ansprüche, ferner umfassend:

    - Bestimmen einer zweiten Abhängigkeit ($\delta K_C/\delta\omega_2$) des Kapazitätsverhältnisses (Kc) von der zweiten Resonanzfrequenz ($\omega_2$).

14. Vorrichtung zum Bestimmen eines Zustands eines kapazitiven Spannungswandlers, wobei der kapazitive Spannungswandler (50) an seiner Primärseite einen kapazitiven Spannungsteiler mit einem ersten Kondensator ($C_1$) und einem zweiten Kondensator ($C_2$) umfasst, wobei der erste Kondensator ($C_1$) einen Hochspannungsanschluss (HV) zum Verbinden mit einer Hochspannung (60) aufweist und der zweite Kondensator ($C_2$) einen Masseanschluss (NHF) aufweist, wobei die Vorrichtung (90) umfasst:

    - eine Messvorrichtung, welche zur Durchführung einer Kurzschlussimpedanzmessung mit einstellbarer Frequenz ausgestaltet ist,

    **gekennzeichnet durch**

    - eine Steuervorrichtung, welche ausgestaltet ist,

        eine erste Resonanzfrequenz ($\omega_e$) mittels mehrerer erster Kurzschlussimpedanzmessungen bei verschiedenen Frequenzen an einer Sekundärseite des kapazitiven Spannungswandler (50) zu bestimmen, während der Hochspannungsanschluss (HV) mit Masse (70) verbunden ist,
eine zweite Resonanzfrequenz ($\omega_2$) mittels mehrerer zweiter Kurzschlussimpedanzmessungen bei verschiedenen Frequenzen an der Sekundärseite des kapazitiven Spannungswandlers (50) zu bestimmen, während der Hochspannungsanschluss (HV) offen ist, und
ein Kapazitätsverhältnis (Kc) des kapazitiven Spannungsteilers in Abhängigkeit von der ersten Resonanzfrequenz ($\omega_e$) und der zweiten Resonanzfrequenz ($\omega_2$) zu bestimmen.

15. Vorrichtung nach Anspruch 14, wobei die Vorrichtung (90) zur Durchführung des Verfahrens nach einem der Ansprüche 1-13 ausgestaltet ist.

**Claims**

1. A method for determining a state of a capacitive voltage transformer, wherein the capacitive voltage transformer (50) comprises on its primary side a capacitive voltage divider with a first capacitor ($C_1$) and a second capacitor ($C_2$), wherein the first capacitor ($C_1$) has a high-voltage terminal (HV) for connection to a high voltage (60) and the second capacitor ($C_2$) has a ground terminal (NHF), wherein the method is **characterized by**:

   - determining a first resonant frequency ($\omega_e$) by way of a plurality of first short-circuit impedance measurements at different frequencies on a secondary side of the capacitive voltage transformer (50) while the high-voltage terminal (HV) is connected to ground (70),
   - determining a second resonant frequency ($\omega_2$) by way of a plurality of second short-circuit impedance measurements at different frequencies on the secondary side of the capacitive voltage transformer (50) while the high-voltage terminal (HV) is open, and
   - determining a capacitance ratio (Kc) of the capacitive voltage divider (50) depending on the first resonant frequency ($\omega_e$) and the second resonant frequency ($\omega_2$).

2. The method according to claim 1, further comprising:

   - determining a measurement current depending on a burden of the capacitive voltage transformer (50) and a voltage drop at the burden of the capacitive voltage transformer (50), wherein the plurality of first short-circuit impedance measurements and the plurality of second short-circuit impedance measurements are carried out using the measurement current.

3. The method according to claim 1 or claim 2,

   wherein the plurality of first short-circuit impedance measurements comprises a plurality of short-circuit impedance measurements in a first frequency grid followed by a plurality of short-circuit impedance measurements in a second frequency grid, wherein the first frequency grid has a greater frequency distance than the second frequency grid, and/or
   wherein the plurality of second short-circuit impedance measurements comprises a plurality of short-circuit impedance measurements in a first frequency grid followed by a plurality of short-circuit impedance measurements in a second frequency grid, wherein the first frequency grid has a greater frequency distance than the second frequency grid.

4. The method according to any one of the preceding claims, further comprising:

   - determining a resonant inductance of the capacitive voltage transformer (50) depending on nominal values of the first and second capacitors ($C_1$, $C_2$) and a nominal frequency of the capacitive voltage transformer (50), and
   - determining an actual value of the capacitance of the second capacitor ($C_2$) depending on the second resonant frequency ($\omega_2$) and the resonant inductance.

5. The method according to claim 4, wherein the resonant inductance is determined independently of an inductive transformation ratio of a transformer of the capacitive voltage transformer.

6. The method according to any one of the preceding claims, further comprising:

- determining a first minimal impedance and a first bandwidth by way of the plurality of first short-circuit impedance measurements at different frequencies on the secondary side of the capacitive voltage transformer (50) while the high-voltage terminal (HV) is connected to ground (70),

- determining a second minimal impedance and a second bandwidth by way of the plurality of second short-circuit impedance measurements at different frequencies on the secondary side of the capacitive voltage transformer (50) while the high-voltage terminal (HV) is open, and

- determining an actual value of the capacitance of the first capacitor $C_1$ and an actual value of the capacitance of the second capacitor $C_2$ depending on the first minimal impedance, the first bandwidth, the second minimal impedance, the second bandwidth and an inductive transformation ratio of a transformer of the capacitive voltage transformer.

7. The method according to claim 6, further comprising:

- comparing the capacitance ratio (Kc), which is determined depending on the first resonant frequency ($\omega_e$) and the second resonant frequency ($\omega_2$), with a capacitance ratio, which is determined depending on the actual value of the capacitance of the first capacitor $C_1$ and the actual value of the capacitance of the second capacitor $C_2$, and

- determining a validity of the determination of the actual value of the capacitance of the first capacitor $C_1$ and the actual value of the capacitance of the second capacitor $C_2$ depending on the comparison.

8. The method according to any one of claims 4 to 7, further comprising:

- determining a plurality of actual values of the capacitance of the second capacitor ($C_2$) at different points in time, and

- representing a temporal trend of the capacitance of the second capacitor ($C_2$) on a display apparatus.

9. The method according to claim 4 or claim 5, further comprising:

- determining an actual value of the capacitance of the first capacitor ($C_1$) depending on the actual value of the capacitance of the second capacitor ($C_2$) and the capacitance ratio (Kc).

10. The method according to any one of claims 6 to 9, further comprising:

- determining a plurality of actual values of the capacitance of the first capacitor ($C_1$) at different points in time, and

- representing a temporal trend of the capacitance of the first capacitor ($C_1$) on a display apparatus.

11. The method according to any one of the preceding claims, further comprising:

- determining a plurality of capacitance ratios (Kc) of the capacitive voltage divider at different points in time, and

- representing a temporal trend of the capacitance ratio (Kc) on a display apparatus.

12. The method according to any one of the preceding claims, further comprising:

- determining a first dependency ($\delta K_C / \delta \omega_e$) of the capacitance ratio (Kc) on the first resonant frequency ($\omega_e$).

13. The method according to any one of the preceding claims, further comprising:

- determining a second dependency ($\delta K_C / \delta \omega_2$) of the capacitance ratio (Kc) on the second resonant frequency ($\omega_2$).

14. An apparatus for determining a state of a capacitive voltage transformer, wherein the capacitive voltage transformer (50) comprises on its primary side a capacitive voltage divider with a first capacitor ($C_1$) and a second capacitor ($C_2$), wherein the first capacitor ($C_1$) has a high-voltage terminal (HV) for connection to a high voltage (60) and the second capacitor ($C_2$) has a ground terminal (NHF), wherein the apparatus (90) comprises:

- a measuring apparatus which is configured for carrying out a short-circuit impedance measurement with an adjustable frequency,

**characterized by**

- a control apparatus which is configured

to determine a first resonant frequency ($\omega_e$) by way of a plurality of first short-circuit impedance measurements at different frequencies on a secondary side of the capacitive voltage transformer (50) while the high-voltage terminal (HV) is connected to ground (70),
to determine a second resonant frequency ($\omega_2$) by way of a plurality of second short-circuit impedance measurements at different frequencies on the secondary side of the capacitive voltage transformer (50) while the high-voltage terminal (HV) is open, and
to determine a capacitance ratio (Kc) of the capacitive voltage divider depending on the first resonant frequency ($\omega_e$) and the second resonant frequency ($\omega_2$).

**15.** The apparatus according to claim 14, wherein the apparatus (90) is configured for carrying out the method according to any one of claims 1-13.

**Revendications**

**1.** Procédé pour la détermination d'un état d'un convertisseur de tension capacitif, dans lequel le convertisseur de tension capacitif (50) comprend, sur son côté primaire, un diviseur de tension capacitif comportant un premier condensateur ($C_1$) et un second condensateur ($C_2$), dans lequel le premier condensateur ($C_1$) présente une borne haute tension (HV) pour la connexion à une haute tension (60) et le second condensateur ($C_2$) présente une borne de masse (NHF), dans lequel le procédé est **caractérisé par** :

- la détermination d'une première fréquence de résonance ($\omega_e$) à l'aide d'une pluralité de premières mesures d'impédance en court-circuit pour différentes fréquences sur un côté secondaire du convertisseur de tension capacitif (50), pendant que la borne haute tension (HV) est connectée à la masse (70),
- la détermination d'une seconde fréquence de résonance ($\omega_2$) à l'aide d'une pluralité de secondes mesures d'impédance en court-circuit pour différentes fréquences sur le côté secondaire du convertisseur de tension capacitif (50), pendant que la borne haute tension (HV) est en circuit ouvert, et
- la détermination d'un rapport de capacité ($K_c$) du diviseur de tension capacitif (50) en fonction de la première fréquence de résonance ($\omega_e$) et de la seconde fréquence de résonance ($\omega_2$).

**2.** Procédé selon la revendication 1, comprenant en outre :

- la détermination d'un courant de mesure en fonction d'une charge du convertisseur de tension capacitif (50) et d'une chute de tension au niveau de la charge du convertisseur de tension capacitif (50), dans lequel la pluralité de premières mesures d'impédance en court-circuit et la pluralité de secondes mesures d'impédance en court-circuit sont réalisées à l'aide du courant de mesure.

**3.** Procédé selon la revendication 1 ou la revendication 2,

dans lequel la pluralité de premières mesures d'impédance en court-circuit comprend une pluralité de mesures d'impédance en court-circuit dans une première trame de fréquence, suivie d'une pluralité de mesures d'impédance en court-circuit dans une seconde trame de fréquences, dans lequel la première trame de fréquences présente un écart de fréquences supérieur à la seconde trame de fréquences, et/ou
dans lequel la pluralité de secondes mesures d'impédance en court-circuit comprend une pluralité de mesures d'impédance en court-circuit dans une première trame de fréquence, suivie d'une pluralité de mesures d'impédance en court-circuit dans une seconde trame de fréquences, dans lequel la première trame de fréquences présente un écart de fréquences supérieur à la seconde trame de fréquences.

**4.** Procédé selon l'une des revendications précédentes, comprenant en outre :

- la détermination d'une inductance à résonance du convertisseur de tension capacitif (50) en fonction de valeurs nominales des premier et second condensateurs ($C_1$, $C_2$) et d'une fréquence nominale du convertisseur de tension capacitif (50), et
- la détermination d'une valeur réelle de la capacité du second condensateur ($C_2$) en fonction de la seconde

fréquence de résonance ($\omega_2$) et de l'inductance à résonance.

5. Procédé selon la revendication 4, dans lequel l'inductance à résonance est déterminée indépendamment d'un rapport de démultiplication inductif d'un transformateur du convertisseur de tension capacitif.

6. Procédé selon l'une des revendications précédentes, comprenant en outre :

   - la détermination d'une première impédance minimale et d'une première bande passante à l'aide de la pluralité de premières mesures d'impédance en court-circuit pour différentes fréquences sur le côté du convertisseur de tension capacitif (50), pendant que la borne haute tension (HV) est connectée à la masse (70),
   - la détermination d'une seconde impédance minimale et d'une seconde bande passante à l'aide d'une pluralité de secondes mesures d'impédance en court-circuit pour différentes fréquences sur le côté secondaire du convertisseur de tension capacitif (50), pendant que la borne haute tension (HV) est en circuit ouvert, et
   - la détermination d'une valeur réelle de la capacité du premier condensateur $C_1$ et d'une valeur réelle de la capacité du second condensateur $C_2$ en fonction de la première impédance minimale, de la première bande passante, de la seconde impédance minimale de la seconde bande passante et d'un rapport de démultiplication inductif d'un transformateur du convertisseur de tension capacitif.

7. Procédé selon la revendication 6, comprenant en outre :

   - la comparaison du rapport de capacité ($K_c$) qui est déterminé en fonction de la première fréquence de résonance ($\omega_e$) et de la seconde fréquence de résonance ($\omega_2$) à un rapport de capacité qui est déterminé en fonction de la valeur réelle de la capacité du premier condensateur $C_1$ et de la valeur réelle de la capacité du second condensateur $C_2$, et
   - la détermination d'une validité de la détermination de la valeur réelle de la capacité du premier condensateur $C_1$ et de la valeur réelle de la capacité du second condensateur $C_2$ en fonction de la comparaison.

8. Procédé selon l'une des revendications 4 à 7, comprenant en outre :

   - la détermination d'une pluralité de valeurs réelles de la capacité du second condensateur ($C_2$) à différents moments, et
   - la représentation d'une tendance temporelle de la capacité du second condensateur ($C_2$) sur un dispositif d'affichage.

9. Procédé selon la revendication 4 ou la revendication 5, comprenant en outre :

   - la détermination d'une valeur réelle de la capacité du premier condensateur ($C_1$) en fonction de la valeur réelle de la capacité du second condensateur ($C_2$) et du rapport de capacité ($K_c$).

10. Procédé selon l'une des revendications 6 à 9, comprenant en outre :

    - la détermination d'une pluralité de valeurs réelles de la capacité du premier condensateur ($C_1$) à différents moments, et
    - la représentation d'une tendance temporelle de la capacité du premier condensateur ($C_1$) sur un dispositif d'affichage.

11. Procédé selon l'une des revendications précédentes, comprenant en outre :

    - la détermination d'une pluralité de rapports de capacité ($K_c$) du diviseur de tension capacitif à différents moments, et
    - la représentation d'une tendance temporelle du rapport de capacité ($K_c$) sur un dispositif d'affichage.

12. Procédé selon l'une des revendications précédentes, comprenant en outre :

    - la détermination d'une première dépendance ($\delta K_c/\delta\omega_e$) du rapport de capacité ($K_c$) de la première fréquence de résonance ($\omega_e$).

13. Procédé selon l'une des revendications précédentes, comprenant en outre :

- la détermination d'une seconde dépendance ($\delta K_c/\delta\omega_2$) du rapport de capacité ($K_c$) de la seconde fréquence de résonance ($\omega_2$).

14. Dispositif pour la détermination d'un état d'un convertisseur de tension capacitif, dans lequel le convertisseur de tension capacitif (50) comprend, sur son côté primaire, un diviseur de tension capacitif comportant un premier condensateur ($C_1$) et un second condensateur ($C_2$), dans lequel le premier condensateur ($C_1$) présente une borne haute tension (HV) pour la connexion à une haute tension (60) et le second condensateur ($C_2$) présente une borne de masse (NHF), dans lequel le dispositif (90) comprend :

   - un dispositif de mesure qui est conçu pour la réalisation d'une mesure d'impédance en court-circuit à fréquence réglable,

   **caractérisé par**

   - un dispositif de commande qui est conçu pour

      déterminer une première fréquence de résonance ($\omega_e$) à l'aide d'une pluralité de premières mesures d'impédance en court-circuit pour différentes fréquences sur un côté secondaire du convertisseur de tension capacitif (50), pendant que la borne haute tension (HV) est connectée à la masse (70),
      déterminer une seconde fréquence de résonance ($\omega_2$) à l'aide d'une pluralité de secondes mesures d'impédance en court-circuit pour différentes fréquences sur le côté secondaire du convertisseur de tension capacitif (50), pendant que la borne haute tension (HV) est en circuit ouvert, et
      déterminer un rapport de capacité ($K_c$) du diviseur de tension capacitif en fonction de la première fréquence de résonance ($\omega_e$) et de la seconde fréquence de résonance ($\omega_2$).

15. Dispositif selon la revendication 14, dans lequel le dispositif (90) est conçu pour la réalisation du procédé selon l'une des revendications 1 à 13.

**Fig. 1**

**Fig. 2**

**Fig. 3**

**Fig. 4**

Impedanz [Ω]

**Fig. 5**

Phase [°]

**Fig. 6**

Impedanz [Ω]

**Fig. 7**

Phase [°]

**Fig. 8**

$\delta K_c/\delta f_2$ [%]

**Fig. 9**

**Fig. 10**

**Fig. 11**

**Fig. 12**

```
┌─────────────────────────────┐
│   Eingabe Typenschilddaten  │─── 1301
└─────────────────────────────┘
              │
              ▼
┌─────────────────────────────┐
│     Messstrom berechnen      │─── 1302
└─────────────────────────────┘
              │
              ▼
┌─────────────────────────────┐
│  Hochspannungsanschluss mit  │─── 1303
│        Masse koppeln         │
└─────────────────────────────┘
              │
              ▼
┌─────────────────────────────┐
│ Resonanzfrequenz $\omega_e$ bestimmen │─── 1304
└─────────────────────────────┘
              │
              ▼
┌─────────────────────────────┐
│    Hochspannungsanschluss    │─── 1305
│         freischalten         │
└─────────────────────────────┘
              │
              ▼
┌─────────────────────────────┐
│ Resonanzfrequenz $\omega_2$ bestimmen │─── 1306
└─────────────────────────────┘
              │
              ▼
┌─────────────────────────────┐
│ Kapazitätsverhältnis bestimmen │─── 1307
└─────────────────────────────┘
              │
              ▼                    ─── 1309
┌─────────────────────────────┐
│   Kapazität $C_2$ bestimmen   │◄──────────┐
└─────────────────────────────┘           │
              │                            │
              ▼                            │
┌─────────────────────────────┐           │
│   Kapazität $C_1$ bestimmen   │─── 1310   │
└─────────────────────────────┘           │
              │                            │
              ▼                            │
┌─────────────────────────────┐           │
│   $C_1$ und $C_2$ anzeigen    │─── 1311   │
└─────────────────────────────┘           │
              │                            │
              ▼                            │
┌─────────────────────────────┐           │
│ Zeitlichen Trendverlauf von $C_1$ und │─── 1312
│      $C_2$ anzeigen          │
└─────────────────────────────┘
```

1308

┌─────────────────────────────┐
│    Resonanzinduktivität      │
│        bestimmen             │
└─────────────────────────────┘

**Fig. 13**

Eingabe Typenschilddaten — 1401

Messstrom berechnen — 1402

Hochspannungsanschluss mit Masse koppeln — 1403

Resonanzfrequenz $\omega_e$ bestimmen — 1404

Hochspannungsanschluss freischalten — 1405

Resonanzfrequenz $\omega_2$ bestimmen — 1406

Kapazitätsverhältnis bestimmen — 1407

Abhängigkeit $\delta K_C / \delta \omega_2$ des Kapazitätsverhältnisses von $\omega_2$ bestimmen — 1408

Abhängigkeit $\delta K_C / \delta \omega_e$ des Kapazitätsverhältnisses von $\omega_e$ bestimmen — 1409

$\delta K_C / \delta \omega_2$ und $\delta K_C / \delta \omega_e$ anzeigen — 1410

Zeitlichen Trendverlauf von $\delta K_C / \delta \omega_2$ und $\delta K_C / \delta \omega_e$ anzeigen — 1411

**Fig. 14**

```
┌─────────────────────────────────────┐
│      Eingabe Typenschilddaten        │  ──── 1501
└─────────────────────────────────────┘
                  │
                  ▼
┌─────────────────────────────────────┐
│        Messstrom berechnen           │  ──── 1502
└─────────────────────────────────────┘
                  │
                  ▼
┌─────────────────────────────────────┐
│   Hochspannungsanschluss mit         │  ──── 1503
│        Masse koppeln                 │
└─────────────────────────────────────┘
                  │
                  ▼
┌─────────────────────────────────────┐
│   Resonanzfrequenz $\omega_e$ und    │  ──── 1504
│     Bandbreite $B_e$ bestimmen       │
└─────────────────────────────────────┘
                  │
                  ▼
┌─────────────────────────────────────┐
│     Hochspannungsanschluss           │  ──── 1505
│         freischalten                 │
└─────────────────────────────────────┘
                  │
                  ▼
┌─────────────────────────────────────┐
│   Resonanzfrequenz $\omega_2$ und    │  ──── 1506
│     Bandbreite $B_2$ bestimmen       │
└─────────────────────────────────────┘
                  │
                  ▼
┌─────────────────────────────────────┐
│   Kapazitätsverhältnis bestimmen     │  ──── 1507
└─────────────────────────────────────┘
                  │
                  ▼
┌─────────────────────────────────────┐
│   Resonanzinduktivität L aus $\omega_e$ │  ──── 1508
│     bzw. $\omega_2$ bestimmen und    │
│   vergleichen; Kapazitäten $C_1$ und │
│         $C_2$ bestimmen              │
└─────────────────────────────────────┘
                  │
                  ▼
┌─────────────────────────────────────┐
│   Überprüfen, ob die Messung gültig  │  ──── 1509
│              ist                     │
└─────────────────────────────────────┘
                  │
                  ▼
┌─────────────────────────────────────┐
│      $C_1$ und $C_2$ anzeigen        │  ──── 1510
└─────────────────────────────────────┘
                  │
                  ▼
┌─────────────────────────────────────┐
│   Zeitlichen Trendverlauf von        │  ──── 1511
│     $C_1$ und $C_2$ anzeigen         │
└─────────────────────────────────────┘
```

**Fig. 15**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 9817053 B2

**In der Beschreibung aufgeführte Nicht-Patentliteratur**

- **GOPP DAVID.** Einflussgrößen bei der modellbasierten Prüfung von kapazitiven Spannungswandlern - Was sind die einflussreichsten Parameter der modellbasierten Prüfung von kapazitiven Spannungswandlern und wie wirken sich diese auf den Übersetzungs-und Phasenfehler aus?. *Masterarbeit Fachhochschule Vorarlberg,* 01. August 2019, 1-104